# EUROPEAN PATENT APPLICATION

(11) **EP 4 761 526 A1**
(43) Date of publication of application: **17.06.2026**
(21) Application number: 24899333.9
(22) Date of filing: 16.08.2024
(51) Int. Cl.: H10F 77/20

(54) **BUSBAR-FREE ELECTRODE STRUCTURE, IBC SOLAR CELL, AND PHOTOVOLTAIC SYSTEM**

(30) Priority: 07.12.2023 CN 202323341171 U
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHU, Haitao, Jinhua, Zhejiang 322000 (CN); JIANG, Fei, Jinhua, Zhejiang 322000 (CN); CHEN, Gang, Jinhua, Zhejiang 322000 (CN)
(74) Representative: EP&C
(86) International application number: PCT/CN2024/112895
(87) International publication number: WO 2025/118685

(57) **Abstract**

The present disclosure relates to the technical field of solar cells and provides a zero-busbar electrode structure, an IBC solar cell, and a photovoltaic system. First end solder joints, which are disposed close to a third edge and at first disconnection regions, are not in contact with first fingers but are electrically connected to a portion of second fingers closest to the third edge. In this case, second fingers close to a first edge can be interconnected. On this basis, the first end solder joints can be disposed, via the electrical connection above, at portions farther from the first edge of a silicon substrate. In this way, during the subsequent soldering of solder ribbons to the first end solder joints, since the first end solder joints are disposed farther from the first edge, a risk of microcracks during the soldering process can be reduced, thereby enhancing the yield of solar cells. Moreover, this configuration also enables the overall current convergence of the second fingers.

## Description

### Technical Field

The present disclosure relates to the technical field of solar cells, and to a zero-busbar electrode structure, an IBC solar cell, a solar cell assembly, and a photovoltaic system.

### Background Art

A back-contact solar cell is a solar cell in which both a P-type doped layer and an N-type doped layer are disposed on the back side of a silicon wafer. In the prior art, to reduce paste usage and lower costs, the back-contact solar cell may adopt a zero-busbar technical solution. In a zero-busbar back-contact solar cell, back-side fingers are typically designed to be discontinuous, and current convergence and output are achieved by arranging solder ribbons in disconnection regions. To enable soldering of the solder ribbons, solder joints need to be provided on the back side of the solar cell.

In related technologies, an initial solder joint of the solder ribbon is positioned too close to the edge of the solar cell, which may easily cause microcracks in the solar cell during the soldering process, thereby reducing the yield.

### Summary

The present disclosure provides a zero-busbar electrode structure, an IBC solar cell, a solar cell assembly, and a photovoltaic system, aiming to solve the technical problem of yield reduction caused by microcracks that are prone to occur in existing IBC solar cells during the soldering process.

The present disclosure is implemented as follows: a zero-busbar electrode structure according to some embodiments of the present disclosure is configured for use in an IBC solar cell. The zero-busbar electrode structure is disposed on a back side of a silicon substrate of the IBC solar cell, and the zero-busbar electrode structure includes:
a plurality of first fingers and a plurality of second fingers, wherein the plurality of first fingers and the plurality of second fingers are alternately and sequentially spaced apart along a first direction and each of which extends along a second direction , and the second direction intersecting the first direction; in the second direction, the silicon substrate includes a first edge and a second edge opposite to each other; in the first direction, the silicon substrate includes a third edge and a fourth edge opposite to each other;
in the second direction, the first fingers include a plurality of spaced first disconnection regions and the second fingers include a plurality of spaced second disconnection regions , wherein the first disconnection region and the second disconnection region are alternately and sequentially spaced apart; the first disconnection regions on adjacent first fingers correspond to each other in the first direction, and the second disconnection regions on adjacent second fingers correspond to each other in the first direction; and
first end solder joints disposed close to the third edge and disposed at the first disconnection regions, wherein the first end solder joints are all not in contact with the first fingers and are all electrically connected to a portion of the second fingers closest to the third edge.

Optionally, the zero-busbar electrode structure further includes: first connecting grid lines and second connecting grid lines disposed at the first disconnection regions, wherein the first connecting grid line and the second connecting grid line are spaced apart along the second direction and each of which extends along the first direction, and the first connecting grid lines and the second connecting grid lines are all not in contact with the first fingers, and the first connecting grid lines and the second connecting grid lines are connected to a portion of the second fingers closest to the third edge..

Optionally, in the first direction, a distance between each of the first end solder joints and the third edge is 1 cm to 3 cm.

Optionally, each of the first connecting grid lines and each of the second connecting grid lines are both connected to at least three second fingers; and/or in the first direction, a length of each of the first connecting grid lines and a length of each of the second connecting grid lines are both at least four times spacing between the first finger and the second finger

Optionally, the zero-busbar electrode structure further includes third connecting grid lines, and the third connecting grid lines are disposed at the first disconnection regions and are not in contact with the first fingers, and each of the third connecting grid lines is connected to one of the first end solder joints and to a portion of the second fingers between the first connecting grid line and the second connecting grid line and the fourth edge.

Optionally, the zero-busbar electrode structure further includes fourth connecting grid lines and fifth connecting grid lines disposed at the first disconnection regions, the fourth connecting grid lines and the fifth connecting grid lines being spaced apart along the second direction and each of which extending along the first direction, and the fourth connecting grid lines and the fifth connecting grid lines are all not in contact with the first fingers and are all connected to a portion of the second fingers closest to the fourth edge; and
second end solder joints disposed close to the fourth edge and disposed at the first disconnection regions, each of the second end solder joints being disposed between one of the fourth connecting grid lines and one of the fifth connecting grid line and is in contact with the fourth connecting grid line and the fifth connecting grid line

Optionally, in the first direction, a distance between each of the second end solder joints and the fourth edge is 1 cm to 3 cm.

Optionally, wherein the zero-busbar electrode structure further includes sixth connecting grid lines, the sixth connecting grid lines being disposed at the first disconnection regions, and each of the sixth connecting grid lines being connected to one of the second end solder joints and to a portion of the second fingers that between the first connecting grid line and the second connecting grid line and the third edge.

Optionally, the zero-busbar electrode structure may further include seventh connecting grid lines and eighth connecting grid lines disposed at the second disconnection regions, wherein the seventh connecting grid line and the eighth connecting grid line are spaced apart along the second direction and each of which extends along the first direction, and the seventh connecting grid lines and the eighth connecting grid lines are not in contact with the second fingers and are connected to a portion of the first fingers closest to the third edge; and
third end solder joints disposed close to the third edge and disposed at the second disconnection regions, wherein each of the third end solder joints is disposed between one of the seventh connecting grid lines and one of the eighth connecting grid line and is in contact with the seventh connecting grid lines and the eighth connecting grid lines.

Optionally, in the first direction, a distance between each of the third end solder joints and the third edge is 1 cm to 3 cm.

Optionally, each of the seventh connecting grid lines and each of the eighth connecting grid lines are both connected to at least three first fingers; and/or in the first direction, a length of each of the seventh connecting grid line and a length of each of the eighth connecting grid line are both at least four times spacing between the first finger and the second finger.

Optionally, the zero-busbar electrode structure further includes ninth connecting grid lines, the ninth connecting grid lines being disposed at the second disconnection regions, and each of the ninth connecting grid lines is connected to one of the third end solder joints and to a portion of the first fingers that between the seventh connecting grid lines and the fourth edge and that between the eighth connecting grid lines and the fourth edge.

Optionally, the zero-busbar electrode structure further includes tenth connecting grid lines and eleventh connecting grid lines disposed at the second disconnection regions, the tenth connecting grid line and the eleventh connecting grid line being spaced apart along the second direction and each of which extending along the first direction, and the tenth connecting grid lines and the eleventh connecting grid lines are not in contact with the second fingers, and the tenth connecting grid lines and the eleventh connecting grid lines are connected to a portion of the first fingers closest to the fourth edge; and
fourth end solder joints disposed close to the fourth edge and disposed at the second disconnection regions, each of the fourth end solder joints being disposed between one of the tenth connecting grid lines and one of the eleventh connecting grid lines and is in contact with the tenth connecting grid line and the eleventh connecting grid line.

Optionally, in the first direction, a distance between each of the fourth end solder joints and the fourth edge is 1 cm to 3 cm.

Optionally, the zero-busbar electrode structure further includes twelfth connecting grid lines, the twelfth connecting grid lines being disposed at the first disconnection regions, and each of the twelfth connecting grid lines being connected to one of the fourth end solder joints and to a portion of the first fingers that between the first connecting grid lines and the third edge and the second connecting grid lines and the third edge.

Optionally, a plurality of first doped layers and a plurality of second doped layers are disposed on the back side of the silicon substrate, the plurality of first doped layers and the plurality of second doped layers being alternately and sequentially arranged along the first direction and each of which extending along the second direction, and the first direction intersecting the second direction; the first fingers are disposed above the first doped layers, and the second fingers are disposed above the second doped layers, and the first fingers do not extend to the first edge of the silicon substrate; and
the zero-busbar electrode structure further includes:
a first edge collecting grid line disposed close to the first edge and extends along the first direction, and the first edge collecting grid line is electrically connected to the first fingers; and
a second edge collecting grid line extending along the first direction, wherein the second edge collecting grid line is disposed between the first edge collecting grid lines and the first edge and disposed above the second doped layers, and the second edge collecting grid line is in contact with at least one of the second doped layers and electrically connected to ends of a portion of the second fingers close to the first edge.

Optionally, a portion of the second fingers pass through the first edge collecting grid line in an insulated manner and are electrically connected to the second edge collecting grid line.

Optionally, the third edge is connected to the first edge via a first chamfer; and
in a direction from the third edge toward the fourth edge, the second finger and the first finger are alternately and sequentially arranged, and a first auxiliary grid line is disposed at the first chamfer, the first auxiliary grid line connecting the second edge collecting grid line to a second finger closest to the third edge.

Optionally, the zero-busbar electrode structure further includes:
a third edge collecting grid line disposed close to the second edge and extends along the first direction, wherein the third edge collecting grid line is electrically connected to the second fingers, and the second fingers do not extend to the second edge, and a polarity of the third edge collecting grid line is opposite to that of the first edge collecting grid lines; and
a fourth edge collecting grid line extending along the first direction, wherein the fourth edge collecting grid line is disposed between the third edge collecting grid line and the second edge and above the first doped layers, and the fourth edge collecting grid line is in contact with at least one of the first doped layers and electrically connected to ends of a portion of the first fingers close to the second edge.

Optionally, a portion of the first fingers pass through the third edge collecting grid line in an insulated manner and are connected to the fourth edge collecting grid line.

Optionally, the third edge is connected to the second edge via a second chamfer; and
in a direction from the third edge toward the fourth edge, the second finger and the first finger are alternately and sequentially arranged, and a third auxiliary grid line is disposed at the second chamfer, the third auxiliary grid line connecting the second fingers disposed at the second chamfer to the third edge collecting grid line.

Optionally, the zero-busbar electrode structure further includes:
a third edge collecting grid line disposed close to the second edge and extends along the first direction, wherein the third edge collecting grid line is electrically connected to the first fingers, the first fingers do not extend to the second edge of the silicon substrate, and a polarity of the third edge collecting grid line is the same as that of the first edge collecting grid line; and
a fourth edge collecting grid line disposed close to the second edge extending along the first direction, wherein the fourth edge collecting grid line is disposed between the third edge collecting grid lines and the second edge and disposed above the second doped layers, and the fourth edge collecting grid line is in contact with at least one of the second doped layers and electrically connected to ends of a portion of the second fingers close to the second edge.

Optionally, a portion of the second fingers pass through the third edge collecting grid line in an insulated manner and are connected to the fourth edge collecting grid line.

Optionally, the third edge is connected to the second edge via a second chamfer; and
in a direction from the third edge toward the fourth edge, the second finger and the first finger are alternately and sequentially arranged, and a fourth auxiliary grid line is disposed at the second chamfer, the fourth auxiliary grid line connecting the fourth edge collecting grid line to one of the second fingers closest to the third edge.

The present disclosure further provides an IBC solar cell, including a plurality of zero-busbar electrode structures of any one of the aspects described above.

The present disclosure further provides a solar cell assembly, including a plurality of IBC solar cells described above.

The present disclosure further provides a photovoltaic system, including the solar cell assembly described above.

In the zero-busbar electrode structure, the IBC solar cell, the solar cell assembly, and the photovoltaic system according to the embodiments of the present disclosure, the first end solder joints, which are disposed close to the third edge and at the first disconnection regions, are not in contact with the first fingers but are electrically connected to a portion of the second fingers closest to the third edge. In this case, the second fingers close to the first edge can be interconnected. On this basis, the first end solder joints can be positioned, via the electrical connection above, at portions farther from the first edge of the silicon substrate. In this way, during the subsequent soldering of solder ribbons to the first end solder joints, since the first end solder joints are disposed farther from the first edge, a risk of microcracks during the soldering process can be reduced, thereby enhancing the yield of the solar cell. Moreover, this configuration also enables the overall current convergence of the second fingers. Furthermore, by disposing the first connecting grid lines and the second connecting grid lines in the first disconnection regions, the first connecting grid lines and the second connecting grid lines are not in contact with the first fingers and are connected to a portion of the second fingers closest to the third edge. The first end solder joints are disposed between the first connecting grid lines and the second connecting grid lines and are in contact with the first connecting grid lines and the second connecting grid lines. In this way, by disposing the first connecting grid lines and the second connecting grid lines in the first disconnection regions, the first end solder joints can be disposed at portions farther from the first edge of the silicon substrate and connected to the first connecting grid lines and the second connecting grid lines. The disposition of the first connecting grid lines and the second connecting grid lines can further reduce the risk of microcracks during the soldering process, thereby enhancing the yield of the solar cells. Moreover, this configuration also enables the overall current convergence of the second fingers.

Additional aspects and advantages of the present disclosure are set forth in part in the following description and, in part, are becoming apparent from the following description, or may be learned through the implementation of the present disclosure.

### Brief Description of the Drawings

FIG. 1 is a schematic structural diagram of an IBC solar cell according to an embodiment of the present disclosure;
FIG. 2 is a partially enlarged schematic diagram of an IBC solar cell in FIG. 1;
FIG. 3 is another schematic structural diagram of an IBC solar cell according to an embodiment of the present disclosure;
FIG. 4 is a partially enlarged schematic diagram of an IBC solar cell in FIG. 3;
FIG. 5 is a schematic cross-sectional diagram of an IBC solar cell in FIG. 3 at a second edge collecting grid line;
FIG. 6 is another partially enlarged schematic diagram of an IBC solar cell according to an embodiment of the present disclosure;
FIG. 7 is a schematic cross-sectional diagram of an IBC solar cell in FIG. 3 at a fourth edge collecting grid line;
FIG. 8 is yet another partially enlarged schematic diagram of an IBC solar cell according to an embodiment of the present disclosure;
FIG. 9 is another schematic structural diagram of an IBC solar cell according to an embodiment of the present disclosure;
FIG. 10 is a schematic cross-sectional diagram of an IBC solar cell in FIG. 9 at a fourth edge collecting grid line;
FIG. 11 is a schematic structural diagram of a cell string according to an embodiment of the present disclosure; and
FIG. 12 is a schematic structural diagram of a photovoltaic system according to an embodiment of the present disclosure.

### Detailed Description of the Embodiments

To make objects, technical solutions, and advantages of the present disclosure more apparent, the present disclosure is further described in detail below with reference to the drawings and embodiments. Examples of the embodiments are shown in the drawings, wherein the same or similar reference numerals refer to the same or similar elements, or elements having the same or similar functions throughout. It is to be noted that the embodiments described below with reference to the drawings are merely exemplary and are intended to explain the present disclosure, and cannot be construed as limiting the present disclosure. In addition, it is to be understood that the specific embodiments described herein are merely intended to explain the present disclosure and are not intended to limit the present disclosure.

In the description of the present disclosure, it is to be understood that the terms "upper", "lower", "left", "right", "transverse", "longitudinal", etc., indicating orientations or positional relationships, are on the basis of orientations or positional relationships shown in the drawings. These terms are used merely to simplify and facilitate the description of the present disclosure, and are not intended to indicate or imply that the referenced apparatuses or elements must have a specific orientation or be constructed and operated in a specific orientation. Therefore, such terms cannot be construed as limitations of the present disclosure.

In addition, the terms "first" and "second" are used merely for descriptive purposes and cannot be construed as indicating or implying relative importance or implicitly indicating the number of the referenced technical features. Accordingly, features defined by "first" or "second" may explicitly or implicitly comprise one or more such features. In the description of the present disclosure, "a plurality of" refers to two or more, unless otherwise explicitly and specifically defined.

In the present disclosure, unless otherwise explicitly specified and defined, a first feature being "above" or "below" a second feature may comprise cases where the first feature and the second feature are in direct contact, and cases where the first feature and the second feature are not in direct contact but are in contact via another feature therebetween. Moreover, the first feature being "above", "on", and "over" the second feature comprises that the first feature is directly above and obliquely above the second feature, or merely indicates that the first feature is at a higher level than the second feature. The first feature being "below", "beneath", and "under" the second feature comprises that the first feature is directly below and obliquely below the second feature, or merely indicates that the first feature is at a lower level than the second feature.

The following disclosure provides numerous different embodiments or examples for implementing various structures of the present disclosure. To simplify the description of the present disclosure, components and configurations of specific examples are described below. Certainly, they are merely exemplary and are not intended to limit the present disclosure. In addition, the present disclosure may repeat reference numerals and/or reference letters in different examples. Such repetition is for simplicity and clarity, and does not in itself indicate a relationship between the various embodiments and/or configurations discussed. In addition, the present disclosure provides examples of various specific processes and materials. However, those skilled in the art may recognize that other processes and/or materials may also be applicable.

### Embodiment 1

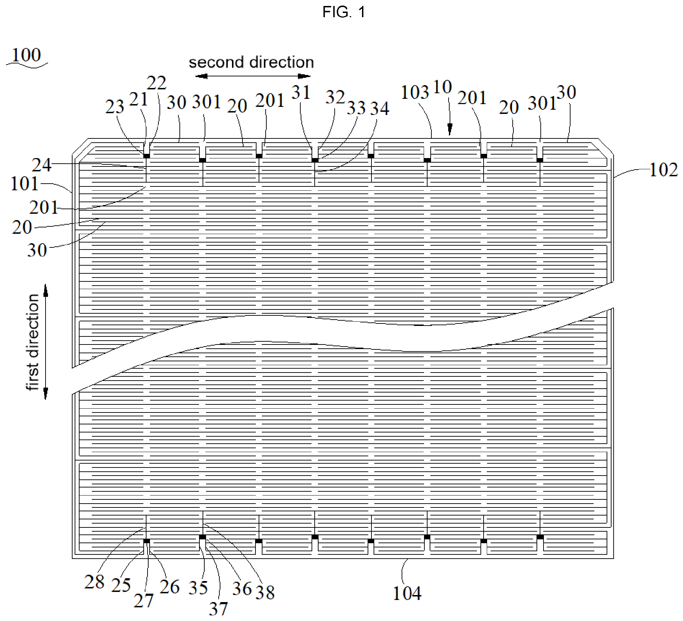

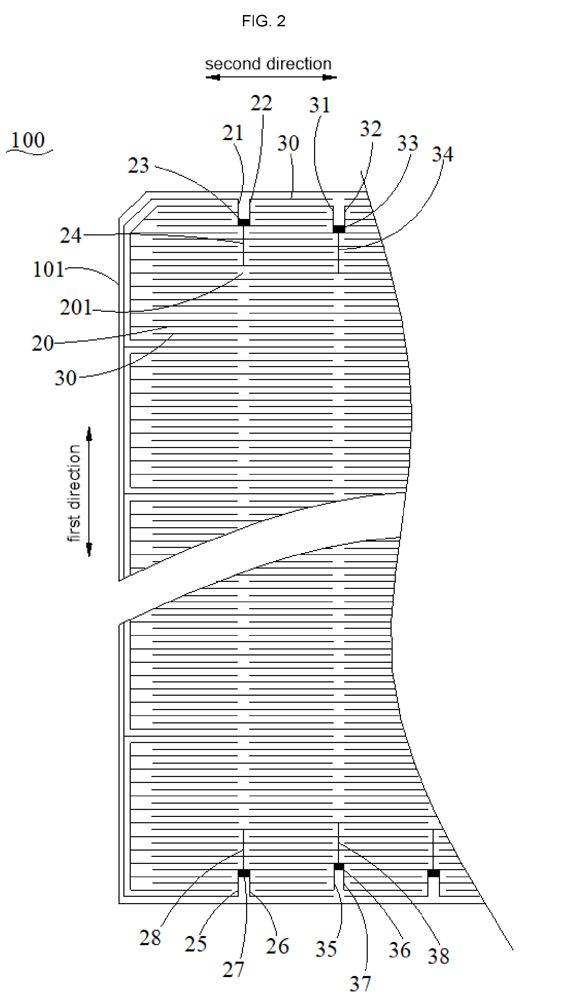

Referring to FIGS. 1 and 2, the IBC solar cell 100 in the embodiments of the present disclosure may comprise a silicon substrate 10 and a zero-busbar electrode structure according to the embodiments of the present disclosure, and the zero-busbar electrode structure is disposed on a back side 11 of the silicon substrate 10.

As shown in FIGS. 1 and 2, the zero-busbar electrode structure may comprise a plurality of first fingers 20, a plurality of second fingers 30, first connecting grid lines 21, second connecting grid lines 22, and first end solder joints 23.

The plurality of first fingers 20 and the plurality of second fingers 30 are alternately spaced apart along a first direction. In a second direction, the silicon substrate 10 includes a first edge 101 and a second edge 102 opposite to each other. In the first direction, the silicon substrate 10 includes a third edge 103 and a fourth edge 104 opposite to each other.

As shown in FIG. 1, the first fingers 20 include a plurality of spaced first disconnection regions 201 in the second direction, and the second fingers 30 include a plurality of spaced second disconnection regions 301 in the second direction.

In the second direction, the first disconnection region 201 and the second disconnection region 301 are alternately and sequentially spaced apart. The first disconnection regions 201 on adjacent first fingers 20 correspond to each other in the first direction, and the second disconnection regions 301 on adjacent second fingers 30 correspond to each other in the first direction.

It is to be noted that "the first disconnection regions 201 on adjacent first fingers 20 correspond to each other in the first direction, and the second disconnection regions 301 on adjacent second fingers 30 correspond to each other in the first direction" means that, in the first direction, the first disconnection regions 201 are substantially aligned, and the second disconnection regions 301 are also substantially aligned. "In the second direction, the first disconnection region 201 and the second disconnection region 301 are alternately and sequentially spaced apart" means that, throughout the entire IBC solar cell 100, the first disconnection region 201 and the second disconnection region 301 are alternately and sequentially arranged in the second direction. The first disconnection regions 201 and the second disconnection regions 301 are configured for disposing solder ribbons to achieve current convergence and output.

The first connecting grid lines 21 and the second connecting grid lines 22 are disposed at the first disconnection regions 201. The first connecting grid line 21 and the second connecting grid line 22 are spaced apart along the second direction and each of which extends along the first direction. The first connecting grid lines 21 and the second connecting grid lines 22 are all not in contact with the first fingers 20, and the first connecting grid lines 21 and the second connecting grid lines 22 are all connected to a portion of the second fingers 30 closest to the third edge 103.

The first end solder joint 23 is disposed close to the third edge 103 and disposed at the first disconnection region 201. The first end solder joint 23 is disposed between the first connecting grid line 21 and the second connecting grid line 22 and in contact with the first connecting grid line 21 and the second connecting grid line 22. That is, the width of the first disconnection region 201 at which the first end solder joint 23 is disposed is greater than the width of the first disconnection region 201 at other portions.

In the zero-busbar electrode structure and the IBC solar cell in the embodiments of the present disclosure, the first connecting grid lines 21 and the second connecting grid lines 22 are disposed in the first disconnection regions 201. The first connecting grid lines 21 and the second connecting grid lines 22 are all not in contact with the first fingers 20, and the first connecting grid lines 21 and the second connecting grid lines 22 are connected to a portion of the second fingers 30 closest to the third edge 103. The first end solder joint 23 is disposed between the first connecting grid line 21 and the second connecting grid line 22 and are in contact with the first connecting grid line 21 and the second connecting grid line 22. In this way, by disposing the first connecting grid lines 21 and the second connecting grid lines 22 in the first disconnection regions 201, the second finger30 close to the first edge 101 can be interconnected, so that the first end solder joint 23 can be positioned somewhere far from the first edge 101 of the silicon substrate 10 and connected to the first connecting grid line 21 and the second connecting grid line 22. In this way, during subsequent soldering of the solder ribbons to the first end solder joints 23, the disposition of the first connecting grid lines 21 and the second connecting grid lines 22 can reduce the risk of microcracks during the soldering process, thereby enhancing the yield of the solar cells. Moreover, this configuration also enables the overall current convergence of the second fingers 30.

In the embodiments of the present disclosure, the first direction may be the longitudinal direction of the IBC solar cell 100, and the second direction may be the transverse direction of the IBC solar cell 100, with the two directions are perpendicular to each other.

"The first fingers 20 include a plurality of first disconnection regions 201" means that the first finger 20 is a discontinuous structure, and the first finger 20 is interrupted at the first disconnection region 201, that is, the first disconnection regions 201 divide the first fingers 20 into a plurality of parts. Similarly, the phrase "the second fingers 30 include a plurality of second disconnection regions 301" means that the second fingers 30 is a discontinuous structure, and the second finger 30 is interrupted at the second disconnection region 301, that is, the second disconnection regions 301 divide the second fingers 30 into a plurality of parts.

In the embodiment shown in FIG. 1, "first edge 101" refers to the left edge in FIG. 1, "second edge 102" refers to the right edge in FIG. 1, "third edge 103" refers to the top edge in FIG. 1, and "fourth edge 104" refers to the bottom edge in FIG. 1.

It is to be noted that the first end solder joint 23 refers to the solder joint in the first disconnection region 201 and closest to the third edge 103. The first connecting grid lines 21 and the second connecting grid lines 22 are all connected to a portion of the second fingers 30 closest to the third edge 103" can be understood as indicating that the first connecting grid lines 21 and the second connecting grid lines 22 are connected to the second fingers 30 between the first end solder joints 23 and the third edge 103.

In some embodiments, a distance between each of the first end solder joints 23 and the third edge 103 is 1 cm to 3 cm.

In this way, by setting the distance between the first end solder joint 23 and the third edge 103 within this reasonable range, it can be ensured that the first end solder joint 23 does not cause microcracks in the silicon substrate 10 during the soldering process, thereby enhancing the yield of the solar cell.

The distance between the first end solder joint 23 and the third edge 103 may be, for example, 1 cm, 1.2 cm, 1.4 cm, 1.6 cm, 1.8 cm, 2 cm, 2.2 cm, 2.4 cm, 2.6 cm, 2.8 cm, 3 cm, or any value within the range from 1 cm to 3 cm, which is not specifically limited here.

In some embodiments, each of the first connecting grid lines 21 and each of the second connecting grid lines 22 are connected to at least three second fingers 30. In this way, the first end solder joints 23 can be positioned farther from the third edge 103, thereby reducing the risk of microcracks.

As shown in FIG. 1 and 2, in the present disclosure, the first connecting grid line 21 and the second connecting grid line 22 are both connected to three second fingers 300 closest to the third edge 103.

In some embodiments, in the first direction, a length of each of the first connecting grid lines 21 and a length of each of the second connecting grid lines 22 are both at least four times the spacing between the first finger 20 and the second finger 30. In this way, the first end solder joints 23 can also be positioned farther from the third edge 103, thereby reducing the risk of microcracks.

As shown in FIG. 1 and FIG. 2, in the first direction, the second finger 30 and the first finger 20 are sequentially arranged. The first connecting grid line 21 and the second connecting grid line 22 are both connected to three second fingers 30 closed to the third edge 103. The length of the first connecting grid line 21 and the length of the second connecting grid line 22 are both four times the spacing between the first finger 20 and the second finger 30.

Referring to FIGS. 1 and 2, in some embodiments, the zero-busbar electrode structure may further include third connecting grid lines 24. The third connecting grid lines 24 are disposed at the first disconnection regions 201 and are not in contact with the first fingers 20. Each of the third connecting grid lines 24 is connected to one of the first end solder joints 23 and to a portion of the second fingers 30 between the first connecting grid line 21 and second connecting grid line 22 and the fourth edge 104.

In this way, in one aspect, the disposition of the third connecting grid lines 24 enable the second finger 30 to have a grid breakage prevention function. In another aspect, since the third connecting grid line 24 is connected to the first end solder joint 23, it can also improve the soldering tension at the first end solder joint 23 during the soldering process, thereby enhancing the reliability of soldering.

As shown in FIGS. 1 and 2, in such an embodiment, a third connecting grid line 24 can be connected to a first end solder joint 23 and to three second fingers 30 below the first end solder joint 23.

### Embodiment 2

Referring to FIGS. 1 and 2, in some embodiments, the zero-busbar electrode structure may further include fourth connecting grid lines 25, fifth connecting grid lines 26, and second end solder joints 27. The fourth connecting grid lines 25 and the fifth connecting grid lines 26 are disposed at the first disconnection regions 201. The fourth connecting grid line 25 and the fifth connecting grid line 26 are spaced apart along the second direction and both extend along the first direction. The fourth connecting grid lines 25 and the fifth connecting grid lines 26 are all not in contact with the first fingers 20, and the fourth connecting grid lines 25 and the fifth connecting grid lines 26 are all connected to a portion of the second fingers 30 closest to the fourth edge 104.

The second end solder joints 27 are disposed close to the fourth edge 104 and disposed at the first disconnection regions 201. Each of the second end solder joints 27 is disposed between one of the fourth connecting grid lines 25 and one of the fifth connecting grid lines 26 and is in contact with the fourth connecting grid line 25 and the fifth connecting grid line 26.

In this way, by disposing the fourth connecting grid lines 25 and the fifth connecting grid lines 26, the second end solder joints 27 can be positioned farther from the fourth edge 104 of the silicon substrate 10. In this way, during subsequent soldering of the solder ribbons to the second end solder joints 27, the disposition of the fourth connecting grid lines 25 and the fifth connecting grid lines 26 can reduce the risk of microcracks during the soldering process, thereby enhancing the yield of the solar cells. Moreover, this configuration also enables the overall current convergence of the second fingers 30.

In the present disclosure, the first end solder joint 23 and the second end solder joint 27 may be disposed at a starting solder joint and an ending solder joint of the first disconnection region 201, respectively. The first end solder joint 23 and the second end solder joint 27 are disposed at the upper end and the lower end of the solar cell, respectively. In this way, by positioning the solder joints for connecting two ends of the solder ribbon farther from the edges of the silicon substrate, the risk of microcracks during the soldering process can be avoided.

Similarly, it is to be noted that the second end solder joint 27 refers to the solder joint in the first disconnection region 201 and closest to the fourth edge 104. "The fourth connecting grid lines 25 and the fifth connecting grid lines 26 are all connected to a portion of the second fingers 30 closest to the fourth edge 104" can be understood as indicating that the fourth connecting grid lines 25 and the fifth connecting grid lines 26 are connected to the second fingers 30 between the second end solder joints 27 and the fourth edge 104.

In some embodiments, a distance between each of the second end solder joints 27 and the fourth edge 104 is 1 cm to 3 cm.

In this way, by setting the distance between the second end solder joint 27 and the fourth edge 104 within this reasonable range, it can be ensured that the second end solder joint 27 does not cause microcracks in the silicon substrate during the soldering process, thereby enhancing the yield of the solar cell.

The distance between the second end solder joint 27 and the fourth edge 104 may be, for example, 1 cm, 1.2 cm, 1.4 cm, 1.6 cm, 1.8 cm, 2 cm, 2.2 cm, 2.4 cm, 2.6 cm, 2.8 cm, 3 cm, or any value within the range from 1 cm to 3 cm, which is not specifically limited here.

In some embodiments, each of the fourth connecting grid lines 25 and each of the fifth connecting grid line 26 are both connected to at least three second fingers 30.

In this way, the second end solder joints 27 can be positioned farther from the fourth edge 104, thereby reducing the risk of microcracks.

As shown in FIGS. 1 and 2, in the present disclosure, the fourth connecting grid line 25 and the fifth connecting grid line 26 are both connected to three second fingers 30 closest to the fourth edge 104.

In some embodiments, in the first direction, the length of the fourth connecting grid line 25 and the length of the fifth connecting grid line 26 are both at least four times the spacing between the first finger 20 and the second finger 30. In this way, the second end solder joints 27 can also be positioned farther from the fourth edge 104, thereby reducing the risk of microcracks.

As shown in FIG. 1, in the first direction, the second finger 30 and the first finger 20 are sequentially arranged. The fourth connecting grid line 25 and the fifth connecting grid line 26 are both connected to three second fingers 30 closed to the third edge 103. The length of the fourth connecting grid line 25 and the length of the fifth connecting grid line 26 are both four times the spacing between the first finger 20 and the second finger 30.

Referring to FIGS. 1 and 2, in some embodiments, the zero-busbar electrode structure further includes sixth connecting grid lines 28. The sixth connecting grid lines 28 are disposed at the first disconnection regions 201. Each of the sixth connecting grid lines 28 is connected to one of the second end solder joints 27 and to a portion of the second fingers 30 between the fourth connecting grid line 24 and the fifth connecting grid lines 25 and 26 and the third edge 103.

In this way, in one aspect, the disposition of the sixth connecting grid lines 28 enables the second finger 30 to have a grid breakage prevention function. In another aspect, since the sixth connecting grid line 28 is connected to the second end solder joint 27, it can also improve the soldering tension at the second end solder joint 27 during the soldering process, thereby enhancing the reliability of soldering.

As shown in FIGS. 1 and 2, in such an embodiment, a sixth connecting grid line 28 can be connected to a second end solder joint 27 and to three second fingers 30 above the second end solder joint 27.

### Embodiment 3

Referring to FIG. 1 and FIG. 2, in some embodiments, the zero-busbar electrode structure may further include seventh connecting grid lines 31, eighth connecting grid lines 32, and third end solder joints 33.

The seventh connecting grid lines 31 and the eighth connecting grid lines 32 are disposed at the second disconnection regions 301. The seventh connecting grid line 31 and the eighth connecting grid line 32 are spaced apart along the second direction and each of which extends along the first direction. The seventh connecting grid lines 31 and the eighth connecting grid lines 32 are all not in contact with the second fingers 30 and are connected to a portion of the first fingers 20 closest to the third edge 103.

The third end solder joints 33 are disposed close to the third edge 103 and disposed at the second disconnection regions 301. Each of the third end solder joints 33 is disposed between one of the seventh connecting grid lines 31 and one of the eighth connecting grid lines 32 and is in contact with the seventh connecting grid line 31 and the eighth connecting grid line 32.

In this way, by disposing the seventh connecting grid lines 31 and the eighth connecting grid lines 32 in the second disconnection regions 301, the first fingers 20 close to the third edge 103 can be interconnected, so that the third end solder joints 33 can be positioned farther from the third edge 103 of the silicon substrate 10 and connected to the seventh connecting grid lines 31 and the eighth connecting grid lines 32. In this way, during subsequent soldering of the solder ribbons to the third end solder joints 33, the disposition of the seventh connecting grid lines 31 and the eighth connecting grid lines 32 can reduce the risk of microcracks during the soldering process, thereby enhancing the yield of the solar cells. Moreover, this configuration also enables the overall current convergence of the first fingers 20.

Similarly, it is to be noted that the third end solder joint 33 refers to the solder joint in the second disconnection region 301 and closest to the third edge 103. "The seventh connecting grid lines 31 and the eighth connecting grid lines 32 are connected to a portion of the second fingers 30 closest to the third edge 103" can be understood as indicating that the seventh connecting grid line 31 and the eighth connecting grid line 32 are connected to the first fingers 20 between the third end solder joint 33 and the third edge 103.

In some embodiments, a distance between each of the third end solder joints 33 and the third edge 103 is 1 cm to 3 cm.

In this way, by setting the distance between the third end solder joint 33 and the third edge 103 within this reasonable range, it can be ensured that the third end solder joint 33 does not cause microcracks in the silicon substrate during the soldering process, thereby enhancing the yield of the solar cell.

The distance between the third end solder joint 33 and the third edge 103 may be, for example, 1 cm, 1.2 cm, 1.4 cm, 1.6 cm, 1.8 cm, 2 cm, 2.2 cm, 2.4 cm, 2.6 cm, 2.8 cm, 3 cm, or any value within the range from 1 cm to 3 cm, which is not specifically limited here.

In some embodiments, each of the seventh connecting grid lines 31 and each of the eighth connecting grid lines 32 are both connected to at least three first fingers 20.

In this way, the third end solder joints 33 can be positioned farther from the third edge 103, thereby reducing the risk of microcracks.

As shown in FIGS. 1 and 2, in the present disclosure, the seventh connecting grid lines 31 and the eighth connecting grid lines 32 may be connected to three first fingers 20 closest to the third edge 103.

In some embodiments, in the first direction, the length of each of the seventh connecting grid lines 31 and the length of each of the eighth connecting grid lines 32 are both at least four times the spacing between the first finger 20 and the second finger 30. In this way, the third end solder joints 33 can also be positioned farther from the third edge 103, thereby reducing the risk of microcracks.

As shown in FIG. 2, in the first direction, the second fingers 30 and the first fingers 20 are sequentially arranged. The seventh connecting grid line 31 and the eighth connecting grid line 32 are both connected to three first fingers 20 closed to the third edge 103. The length of the seventh connecting grid line 31 and the length of the eighth connecting grid line 32 are four times the spacing between the first finger 20 and the second finger 30.

Referring to FIGS. 1 and 2, in some embodiments, the zero-busbar electrode structure may further include ninth connecting grid lines 34. The ninth connecting grid lines 34 are disposed at the second disconnection regions 301. Each of the ninth connecting grid lines 34 is connected to one of the third end solder joints 33 and to a portion of the first fingers 20 between the seventh connecting grid lines 31 and the eighth connecting grid lines and 32 and the fourth edge 104.

In this way, in one aspect, the disposition of the ninth connecting grid line 34 enables the first finger 20 to include a grid breakage prevention function. In another aspect, since the ninth connecting grid line 34 is connected to the third end solder joint 33, it can also improve the soldering tension at the third end solder joint 33 during the soldering process, thereby enhancing the reliability of soldering.

As shown in FIG. 2, in such an embodiment, a ninth connecting grid line 34 may be connected to a third end solder joint 33 and to three first fingers 20 below the third end solder joint 33.

### Embodiment 4

Referring again to FIGS. 1 and 2, in some embodiments, the zero-busbar electrode structure may further include tenth connecting grid lines 35, eleventh connecting grid lines 36, and fourth end solder joints 37.

The tenth connecting grid lines 35 and the eleventh connecting grid lines 36 are disposed at the first disconnection regions. The tenth connecting grid lines 35 and the eleventh connecting grid lines 36 are spaced apart along the second direction and each of which extends along the first direction. The tenth connecting grid lines 35 and the eleventh connecting grid lines 36 are not in contact with the second fingers 30, and the tenth connecting grid lines 35 and the eleventh connecting grid lines 36 are connected to a portion of the first fingers 20 closest to the fourth edge 104.

The fourth end solder joints 37 are disposed close to the fourth edge 104 and disposed at the second disconnection regions 301. Each of the fourth end solder joints 37 is disposed between one of the tenth connecting grid lines 35 and one of the eleventh connecting grid lines 36 and is in contact with the tenth connecting grid line 35 and the eleventh connecting grid line 36.

In this way, by disposing the tenth connecting grid lines 35 and the eleventh connecting grid lines 36, the fourth end solder joints 37 can be positioned farther from the fourth edge 104 of the silicon substrate 10. In this way, during subsequent soldering of the solder ribbons to the fourth end solder joints 37, the disposition of the tenth connecting grid lines 35 and the eleventh connecting grid lines 36 can reduce the risk of microcracks during the soldering process, thereby enhancing the yield of the solar cells. Moreover, this configuration also enables the overall current convergence of the second fingers 30.

In the present disclosure, a third end solder joint 33 and a fourth end solder joint 37 may be disposed at a starting solder joint and an ending solder joint of the second disconnection region 301, respectively. In this way, by positioning the solder joints at two ends of the solder ribbon farther from the edges of the silicon substrate 10, the risk of microcracks during the soldering process can be avoided.

Similarly, it is to be noted that "the tenth connecting grid lines 35 and the eleventh connecting grid lines 36 are connected to a portion of the second fingers 30 closest to the fourth edge 104" may be understood as indicating that the tenth connecting grid line 35 and the eleventh connecting grid line 36 are connected to the first fingers 20 between the fourth end solder joint 37 and the fourth edge 104.

In some embodiments, a distance between each of the fourth end solder joints 37 and the fourth edge 104 is 1 cm to 3 cm.

In this way, by preferably setting the distance between each of the fourth end solder joints 37 and the fourth edge 104 within this reasonable range, it can be ensured that the fourth end solder joints 37 do not cause microcracks in the silicon substrate during the soldering process, thereby enhancing the yield of the solar cell.

The distance between the fourth end solder joint 37 and the fourth edge 104 may be, for example, 1 cm, 1.2 cm, 1.4 cm, 1.6 cm, 1.8 cm, 2 cm, 2.2 cm, 2.4 cm, 2.6 cm, 2.8 cm, 3 cm, or any value within the range from 1 cm to 3 cm, which is not specifically limited herein.

In some embodiments, each of the tenth connecting grid lines 35 and each of the eleventh connecting grid lines 36 are both connected to at least three first fingers 20.

In this way, the fourth end solder joints 37 can be positioned farther from the fourth edge 104, thereby reducing the risk of microcracks.

As shown in FIG. 1, in the present disclosure, the tenth connecting grid line 35 and the eleventh connecting grid line 36 may be connected to three first fingers 20 closest to the fourth edge 104.

In some embodiments, in the first direction, the length of each of the tenth connecting grid line 35 and the length of each of the eleventh connecting grid line 36 are both at least four times the spacing between the first finger 20 and the second finger 30. In this way, the fourth end solder joints 37 can also be positioned farther from the fourth edge 104, thereby reducing the risk of microcracks.

As shown in FIG. 1, in the first direction, the second finger 30 and the first finger 20 are sequentially arranged. The tenth connecting grid line 35 and the eleventh connecting grid line 36 are connected to three first fingers 20 closed to the third edge 103. The length of the tenth connecting grid line 35 and the length of the eleventh connecting grid line 36 are both four times the spacing between the first finger 20 and the second finger 30.

Referring to FIG. 2, in some embodiments, the zero-busbar electrode structure may further include twelfth connecting grid lines 38. The twelfth connecting grid lines 38 are disposed at the second disconnection region 301. Each of the twelfth connecting grid lines 38 is connected to one of the fourth end solder joints 37 and to a portion of the first fingers 20 between the tenth connecting grid lines 35 and the eleventh connecting grid line 36 and the third edge 103.

In this way, in one aspect, the disposition of the twelfth connecting grid line 38 enables the second finger 30 to have a grid breakage prevention function. In another aspect, since the twelfth connecting grid line 38 is connected to the fourth end solder joint 37, it can also improve the soldering tension at the fourth end solder joint 37 during the soldering process, thereby enhancing the reliability of soldering.

As shown in FIG. 2, in such an embodiment, a twelfth connecting grid line 38 may be connected to a fourth end solder joint 37 and to three first fingers 20 above the fourth end solder joint 37.

### Embodiment 5

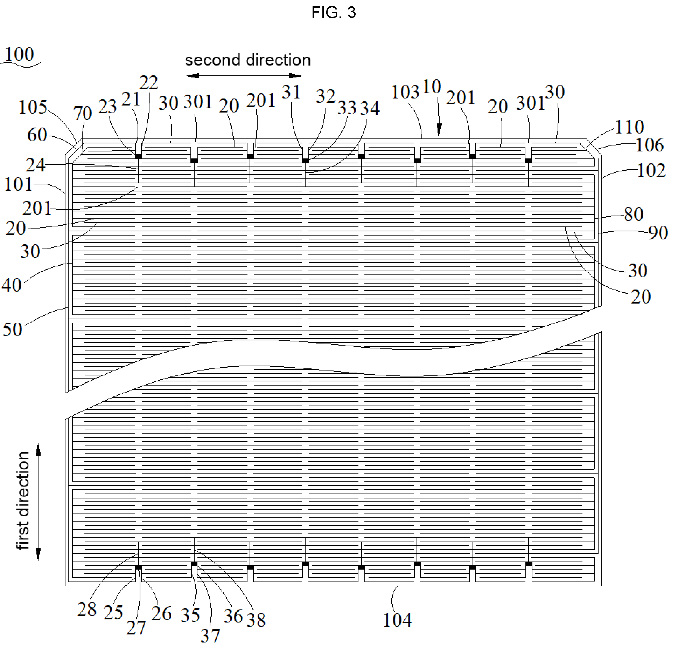

Referring to FIGS. 3 to 5, in some embodiments, a plurality of first doped layers 12 and a plurality of second doped layers 13 are disposed on the back side 11 of the silicon substrate 10. The plurality of first doped layers 12 and the plurality of second doped layers 13 are alternately and sequentially arranged along the first direction and each of which extends along the second direction, the first direction intersecting the second direction. In the second direction, the silicon substrate 10 includes a first edge 101 and a second edge 102 opposite to each other.

The zero-busbar electrode structure may further include a first edge collecting grid line 40 and a second edge collecting grid line 50. A plurality of first doped layers 12 and a plurality of second doped layers 13 are disposed on the back side 11 of the silicon substrate 10. The plurality of first doped layers 12 and the plurality of second doped layers 13 are alternately and sequentially arranged along the first direction and each of which extends along the second direction.

The first doped layer 12 includes a polarity opposite to that of the second doped layer 13. For example, the first doped layer 12 may be a P-type doped layer, and the second doped layer 13 may be an N-type doped layer. For another example, the first doped layer 12 may be an N-type doped layer, and the second doped layer 13 may be a P-type doped layer, which is not specifically limited herein. The first doped layers 12 and the second doped layers 13 may be spaced apart, and the first doped layer 12 and the second doped layer 13 may extend to the first edge 101 and the second edge 102 of the silicon substrate 10.

The first fingers 20 are disposed above the first doped layers 12, and the second fingers 30 are disposed on the second doped layers 13. The first finger 20 is configured to collect current of the first doped layer 12, and the second finger 30 is configured to collect current of the second doped layer 13. The first fingers 20 do not extend to the first edge 101 of the silicon substrate 10.

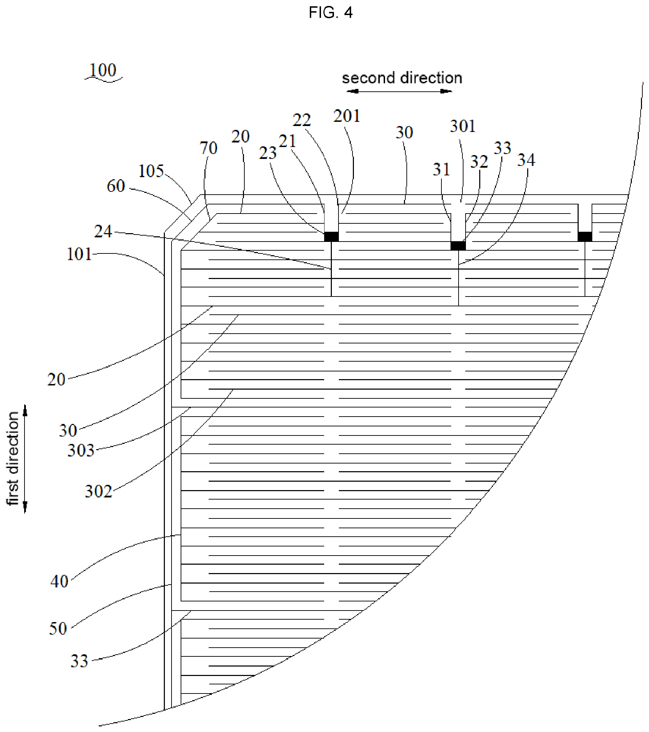

Referring to FIGS. 3 and 4, the first edge collecting grid line 40 is disposed close to the first edge 101 and extends along the first direction, and the first edge collecting grid line 40 is electrically connected to the first fingers 20.

The second edge collecting grid line 50 extends along the first direction, and is disposed between the first edge collecting grid line 40 and the first edge 101 and disposed above the second doped layers 13. The second edge collecting grid line 50 is in contact with at least one of the second doped layers 13 and are electrically connected to ends of a portion of the second fingers 30 close to the first edge 101.

The second edge collecting grid line 50 may be directly connected to a portion of the second fingers 30, or may be connected to a portion of the second fingers 30 via other connecting lines ( for example, a first auxiliary grid line 60 described below). It is to be noted that "a portion of the second fingers 30" refers to one second finger 30 or a plurality of second fingers 30 but not all of the second fingers 30.

It is to be understood that, in the related art, the back-side fingers of a back-contact solar cell typically do not extend to the lateral edges of the silicon wafer. This is because, if the fingers extend to the edge regions, to collect the current from the fingers in the edge regions, it is necessary to dispose solder ribbons at the edges to connect to the fingers in the edge regions. If the fingers with opposite polarity to the solder ribbons extend to the edges of the silicon wafer, it is necessary to apply an insulating adhesive between the edge-disposed solder ribbons and each of the opposite-polarity fingers to prevent electrical contact. This not only significantly increases manufacturing costs but also raises the risk of adhesive leakage, which may result in defects such as bending or warping of the solar cell.

However, if the fingers do not extend to the edges of the silicon wafer, certain edge regions lack metal fingers, making it impossible to collect carriers in a portion of the edges. This reduces the carrier collection efficiency, then leads to energy loss, and ultimately lowers the efficiency of the solar cell.

Therefore, in the present disclosure, by disposing the second edge collecting grid line 50 between the first edge 101 and the first edge collecting grid line 40, and enabling the second edge collecting grid line 50 to contact at least one of the second doped layers 13 and be connected to a portion of the second fingers 30, the second edge collecting grid line 50 can collect current from the second doped layer 13 in the edge region at the first edge 101 and converge the current via the portion of the second fingers 30 to an adjacent same-polarity solder ribbon, thereby achieving current collection. This configuration can effectively reduce efficiency loss in the edge region of the first edge 101 and improve the efficiency of the solar cell.

In addition, since only a portion of the second fingers 30 are connected to the second edge collecting grid line 50, during the subsequent soldering process of the opposite-polarity solder ribbons (for example, the edge solder ribbons 220 described below), the solder ribbons only intersect a portion of the second fingers 30 or the connecting lines that connect the second fingers 30 with the second edge collecting grid line 50 (for example, the first auxiliary grid line 60 described below). As there are fewer intersection joints, insulating adhesive only needs to be applied at a limited number of discrete joints to prevent leakage, thereby effectively reducing costs. Moreover, the application joints of the insulating adhesive are isolated, making adhesive leakage less likely and thus preventing bending or warping of the solar cell. That is to say, the technical solution provided in the present disclosure can effectively reduce the cost of insulating adhesive and avoid bending or warping of the solar cell caused by adhesive leakage, while also minimizing efficiency loss and ensuring the performance of the solar cell. In addition, the disposition of the first edge collecting grid line 40 enables the first finger 20 to have a grid breakage prevention function, thereby minimizing the risk of grid breakage in the first finger 20.

In the embodiments of the present disclosure, the first doped layer 12 has a polarity opposite to that of the second doped layer 13, and the first finger 20 also has a polarity opposite to that of the second finger 30. For example, the first finger 20 may be a positive electrode finger configured to collect positive electrode current from the positive electrode region, then the second finger 30 may be a negative electrode finger configured to collect negative electrode current from the negative electrode region. Alternatively, the first finger 20 may be a negative electrode finger configured to collect negative electrode current from the negative electrode region, then the second finger 30 may be a positive electrode finger configured to collect positive electrode current from the positive electrode region. The positive electrode finger is disposed on the P-type doped layer of the IBC solar cell 100, while the negative electrode finger is disposed on the N-type doped layer of the IBC solar cell 100.

In the embodiments of the present disclosure, to reduce manufacturing complexity, it can be no first fingers 20 provided between the first edge collecting grid line 40 and the first edge 101, and that neither the first fingers 20 nor the second fingers 30 are provided between the second edge collecting grid line 50 and the first edge 101. It is to be understood that, in some embodiments, second fingers 30 may be provided between the second edge collecting grid line 50 and the first edge 101, while the first fingers 20 are absent, which is not specifically limited herein.

In the embodiments of the present disclosure, the first finger 20 and the second finger 30 may be aluminum grid lines, silver grid lines, copper grid lines, or silver-plated copper grid lines, which is not limited herein.

It is to be understood that, in the embodiments of the present disclosure, the first finger 20 and the second finger 30 may be selected as grid lines made of the same or different types of metal. For example, the first finger 20 and the second finger 30 may be aluminum grid lines. Alternatively, the first finger 20 may be an aluminum grid line, while the second finger 30 may be a silver grid line.

As shown in FIGS. 3 and 4, it is not difficult to understand that the second edge collecting grid line 50 is in contact with the second doped layer 13 to collect current from the second doped layer 13 in the edge region. Therefore, in the embodiments of the present disclosure, among the first disconnection regions 201 of the first fingers 20 and the second disconnection regions 301 of the second fingers 30, the first disconnection regions 201 are closest to the first edge 101. That is, in the second direction, the first disconnection region 201 and the second disconnection region 301 are alternately and sequentially arranged. At portions corresponding to the first disconnection regions 201, the second fingers 30 remain continuous, so that the solder ribbon in contact with the second finger 30 can be disposed at such portions, to enable current convergence from the first edge collecting grid line 40.

### Embodiment 6

Referring to FIG. 4, in some embodiments, a portion of the second fingers 30 pass through the first edge collecting grid line 40 in an insulated manner and are electrically connected to the second edge collecting grid line 50.

In this way, after collecting the current from the second doped layer 13 in the edge region of the first edge 101, the second edge collecting grid line 50 can converge current via the second fingers 30, which passes through the first edge collecting grid line 40, to the nearest same-polarity solder ribbon, thereby enabling current collection.

Optionally, as shown in FIG. 4, in such an embodiment, the plurality of second fingers 30 may include a plurality of first collecting fingers 302 and a plurality of first through fingers 303. The plurality of first collecting fingers 302 are all disposed on the side of the first edge collecting grid line 40 facing the second edge 102, while the first through fingers 303 pass through the first edge collecting grid line 40 in an insulated manner and are connected to the second edge collecting grid line 50.

That is to say, in such an embodiment, no first collecting fingers 302 are provided between the first edge collecting grid line 40 and the first edge 101. Only at the portions where the first edge collecting grid line 40 is passed through are first through fingers 303 provided. No other grid lines (comprising the first fingers 20 and the second fingers 30) are present in the remaining portions between the first edge collecting grid line 40 and the first edge 101.

It is to be noted that, in the embodiments of the present disclosure, "a portion of the second fingers 30 pass through the first edge collecting grid line 40 in an insulated manner" can be understood as that in the first direction, the first edge collecting grid line 40 includes a plurality of spaced disconnection regions, and the first through fingers 303 pass through the first edge collecting grid line 40 via the disconnection regions without contacting the first edge collecting grid line 40, thereby achieving physical through-extension and electrical insulation.

It is to be understood that in such an embodiment, the number of first through fingers 303 may be one or more, and the specific number can be determined according to the size of the solar cell. When the number of the first through fingers 303 is more than one, the plurality of first through fingers 303 may be spaced apart along the first direction. The distance between two adjacent first through fingers 303 may be determined according to the size of the solar cell. Optionally, the first through fingers are uniformly spaced along the first direction on the silicon substrate 10 according to the length of the silicon substrate 10, which is not specifically limited herein.

It is not difficult to understand that, in such an embodiment, the second edge collecting grid line 50 can collect the current from the second doped layers 13 in the edge region of the first edge 101, and then converge the current via the first through fingers 303, which pass through the first edge collecting grid line 40, to the nearest same-polarity solder ribbon (for example, the solder ribbon 210 described below), thereby enabling current convergence. By disposing a plurality of first through fingers 303, the current convergence path can be effectively shortened, thereby reducing power loss.

Referring to FIGS. 3 and 4, in some embodiments, the third edge 103 is connected to the first edge 101 via a first chamfer 105.

In a direction from the third edge 103 toward the fourth edge 104, the second finger 30 and the first finger 20 are alternately and sequentially arranged. A first auxiliary grid line 60 is disposed at the first chamfer 105, the first auxiliary grid line 60 connecting the second edge collecting grid line 50 to the second fingers 30 closest to the third edge 103.

In this way, by disposing a first auxiliary grid line 60 at the first chamfer 105, the current collected by the second edge collecting grid line 50 can be converged to the second finger 30 at the third edge 103, and then further converged to the nearest solder ribbon.

Optionally, as shown in FIG. 3, the third edge 103 is a top edge of the silicon substrate 10, and the fourth edge 104 is a bottom edge of the silicon substrate 10. The first edge 101 and the third edge 103 form a first chamfer 105. In such an embodiment, a first auxiliary grid line 60 is disposed at the first chamfer 105 to connect the second edge collecting grid line 50 to the uppermost second finger 30. The current collected by the second edge collecting grid line 50 can be converged via the first auxiliary grid line 60 and via the second finger 30 connected to the first auxiliary grid line 60 to a nearby solder ribbon. That is, the second edge collecting grid line 50 can be electrically connected to the uppermost second finger 30 via the first auxiliary grid line 60.

It is to be understood that, in such an embodiment, the first through fingers 303 and the first auxiliary grid line 60 in the embodiment above may be provided together to achieve current convergence, or the first through fingers 303 in the embodiment above may be omitted, and current convergence may instead be achieved via the first auxiliary grid line 60 at the first chamfer 105. To avoid excessive losses caused by an overly long current convergence path, current convergence may be achieved via the first through fingers 303 alone or jointly via the first through fingers 303 and the first auxiliary grid line 60, which is not limited herein.

As shown in FIG. 4, in some embodiments, the first auxiliary grid line 60 may be disposed in parallel with the first chamfer 105. This arrangement can simplify the fabrication of the grid line structure on the back side 11.

Optionally, in some embodiments, the first auxiliary grid line 60 may be disposed above the second doped layer 13 and in contact with at least one of the second doped layers 13.

In this way, the first auxiliary grid line 60 can not only achieve current convergence, but also collect the current in the edge region at the first chamfer 105, thereby further reducing efficiency loss and improving the efficiency of the solar cell.

Referring to FIGS. 3 and 4, in some embodiments, a second auxiliary grid line 70 may be further disposed at the first chamfer 105, and the second auxiliary grid line 70 connects the first fingers 20 disposed at the first chamfer 105 to the first edge collecting grid line 40. It is to be noted that "the first fingers 20 disposed at the first chamfer 105" refers to those among the plurality of first fingers 20 that are not directly connected to the first edge collecting grid line 40 and intersect the first chamfer 105 along the extension lines in the second direction, for example, the uppermost two first fingers 20 in FIG. 4.

In this way, by disposing the second auxiliary grid line 70, the first fingers 20 at the first chamfer 105 can be electrically connected to each other, thereby enabling conduction among the first fingers 20 at the first chamfer 105. During the subsequent soldering of solder ribbons (for example, the edge solder ribbon 220 described below), it is only necessary to bring the solder ribbon into contact with the second auxiliary grid line 70 to achieve current collection from the first fingers 20 at the first chamfer 105. This can prevent the issue where, during the subsequent soldering of the solder ribbons, due to the presence of the first chamfer 105, the solder ribbons fail to contact all of the first fingers 20 at the first chamfer 105, resulting in unsuccessful current collection from the first fingers 20 at the first chamfer 105.

Optionally, as shown in FIG. 4, in such an embodiment, the second auxiliary grid line 70 may also be disposed in parallel with the first chamfer 105. That is, at the first chamfer 105, from the outer side to the inner side, the first chamfer 105, the first auxiliary grid line 60, and the second auxiliary grid line 70 are sequentially disposed in parallel.

As shown in FIG. 4, it is not difficult to understand that, since the first fingers 20 include first disconnection regions 201 at the portion closest to the first edge 101, to enable current convergence of the first fingers 20 near the first edge 101, solder ribbons need to be disposed at the first edge 101 to establish electrical connection with the first fingers 20 for current convergence. However, due to the presence of the first chamfer 105, the uppermost first fingers 20 are relatively short. When the solder ribbon is vertically disposed, it cannot make contact with the uppermost first fingers 20. If the solder ribbon is disposed too far inward, it may easily come into contact with the opposite-polarity second fingers 30, resulting in leakage. Therefore, by disposing the second auxiliary grid line 70, the first fingers 20 at the first chamfer 105 can be interconnected as a whole. During soldering the solder ribbons, it is only necessary to make the solder ribbons in contact with the first edge collecting grid line 40, or simultaneously in contact with both the first edge collecting grid line 40 and the second auxiliary grid line 70, or in contact with other first fingers 20 connected to the first edge collecting grid line 40 and the second auxiliary grid line 70, to achieve current convergence from all of the first fingers 20.

In some embodiments, the distance between the first edge collecting grid line 40 and the first edge 101 (their spacing in the second direction) is 0.5 mm to 2 mm.

In this way, by setting the spacing between the first edge collecting grid line 40 and the first edge 101 within this reasonable range, it is possible to effectively avoid excessive distance that may result in an overly large area in the edge region without fingers, which would otherwise lead to significant efficiency loss, and also to avoid too small distance that could lead to poor soldering or wafer chipping during subsequent soldering the solder ribbon at the first edge collecting grid line 40, thereby ensuring reliability and stability of soldering.

Optionally, in such an embodiment, the distance between the first edge collecting grid line 40 and the first edge 101 may be, for example, 0.5 mm, 0.6 mm, 0.7 mm, 0.8 mm, 0.9 mm, 1 mm, 1.2 mm, 1.4 mm, 1.6 mm, 1.8 mm, 2 mm, or any value within the range from 0.5 mm to 2 mm, which is not specifically limited herein.

Optionally, in the embodiments of the present disclosure, the distance between the first edge collecting grid line 40 and the first edge 101 may be 0.8 mm to 1.2 mm, for example, 0.9 mm. This configuration can reduce process complexity while effectively preventing excessive distance that may result in an overly large area in the edge region, which would otherwise lead to significant efficiency loss. Moreover, it ensures the stability and reliability of soldering.

In some embodiments, the distance between the second edge collecting grid line 50 and the first edge 101 (their spacing in the second direction) is 0.3 mm to 1.2 mm.

In this way, in one aspect, it can prevent the distance between the second edge collecting grid line 50 and the first edge 101 from being too small, which would significantly increase the printing difficulty of the second edge collecting grid line 50, and in another aspect, it can also avoid excessive efficiency loss caused by an overly large distance between the second edge collecting grid line 50 and the first edge 101.

Optionally, in such an embodiment, the distance between the second edge collecting grid line 50 and the first edge 101 may be, for example, 0.3 mm, 0.4 mm, 0.5 mm, 0.6 mm, 0.7 mm, 0.8 mm, 0.9 mm, 1 mm, 1.2 mm, or any value within the range from 0.3 mm to 1.2 mm, which is not specifically limited herein.

Optionally, in the embodiments of the present disclosure, the distance between the second edge collecting grid line 50 and the first edge 101 may be 0.3 mm to 0.6 mm, for example, 0.5 mm. This configuration can reduce process complexity while effectively preventing excessive distance that may result in an overly large area in the edge region, which would otherwise lead to significant efficiency loss. That is, it can reduce the printing difficulty while preventing significant efficiency loss.

In some embodiments, the width of the second edge collecting grid line 50 may be 20 um to 200 um.

In this way, by setting the width of the second edge collecting grid line 50 within this reasonable range, it is possible to avoid the occurrence of fusing during current convergence due to insufficient current-carrying capacity caused by an excessively small width of the second edge collecting grid line 50, and also to avoid a significant increase in cost due to an excessively large width of the second edge collecting grid line 50.

In such an embodiment, the width of the second edge collecting grid line 50 may be, for example, 20 um, 30 um, 40 um, 50 um, 60 um, 70 um, 80 um, 90 um, 100 um, 110 um, 120 um, 130 um, 140 um, 150 um, 160 um, 170 um, 180 um, 190 um, 200 um, or any value within the range from 20 um to 200 um, which is not specifically limited herein.

In some embodiments, the width of the second edge collecting grid line 50 may be greater than the width of the first edge collecting grid line 40.

In this way, since the second edge collecting grid line 50 serves to collect the current from the second doped layers 13 in the edge region and thus functions in both current collection and current convergence, configuring the width of the second edge collecting grid line 50 to be greater than that of the first edge collecting grid line 40 can enhance the current-carrying capacity of the second edge collecting grid line 50, thereby ensuring the stability of the solar cell.

### Embodiment 7

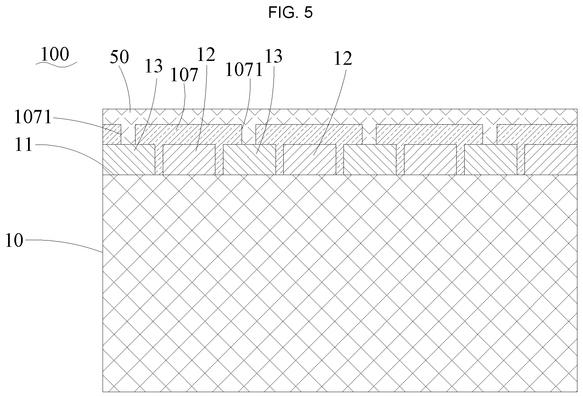

Referring to FIG. 5, in some embodiments, a passivation film layer 107 is further disposed on the first doped layers 12 and the second doped layers 13. The second edge collecting grid line 50 is disposed on the passivation film layer 107. In the region corresponding to the second edge collecting grid line 50 (the projection region of the second edge collecting grid line 50 on the passivation film layer 107), first openings 1071 are disposed at the portions of the passivation film layer 107 corresponding to the second doped layers 13, such that the second edge collecting grid line 50 is in contact with the second doped layer 13 via the first opening 1071.

In this way, by forming the first openings 1071 at the portions of the passivation film layer 107 corresponding to the second doped layer 13, the second edge collecting grid line 50 can be brought into stable contact with the second doped layers 13 under the edge region during printing to enable current collection, while also preventing the second edge collecting grid line 50 from coming into contact with the first doped layers 12, which would otherwise cause current leakage.

Optionally, in such an embodiment, the first openings 1071 may be formed in the passivation film layer 107 by laser ablation. To achieve maximum current collection, the first openings 1071 can be formed above all of the second doped layers 13, so that the second edge collecting grid line 50 can in contact with all of the second doped layers 13 via the first openings 1071, thereby enabling maximum current collection. It is to be understood that in such an embodiment, the first openings 1071 may be formed above all of the second doped layers 13, or may be formed only above a portion of the second doped layers 13, which is not specifically limited herein.

### Embodiment 8

Referring to FIGS. 3, 6, and 7, in some embodiments, the IBC solar cell 100 may further include third edge collecting grid line 80 and fourth edge collecting grid line 90.

The third edge collecting grid line 80 are disposed close to the second edge 102 and extends along the first direction. The third edge collecting grid line 80 is electrically connected to the second fingers 30, the second fingers 30 do not extend to the second edge 102 of the silicon substrate 10, and the polarity of the third edge collecting grid line 80 is opposite to that of the first edge collecting grid line 40.

The fourth edge collecting grid line 90 also extends along the first direction. The fourth edge collecting grid line 90 is disposed between the third edge collecting grid line 80 and the second edge 102 and above the first doped layers 12. The polarity of the fourth edge collecting grid line 90 is opposite to that of the second edge collecting grid line 50 and are in contact with at least one of the first doped layers 12 and are electrically connected to ends of a portion of the first fingers 20 close to the second edge 102.

In this way, the fourth edge collecting grid line 90 is disposed between the second edge 102 and the third edge collecting grid line 80 , the fourth collecting grid line 90 being in contact with at least one of the first doped layers 12 and being connected to a portion of the first fingers 20, so that the fourth edge collecting grid line 90 can collect current from the first doped layers 12 in the edge region at the second edge 102 and converge the current via the portion of the first fingers 20 to an adjacent same-polarity solder ribbon, thereby achieving current collection. This configuration can effectively reduce efficiency loss in the edge region of the second edge 102 and improve the efficiency of the solar cell.

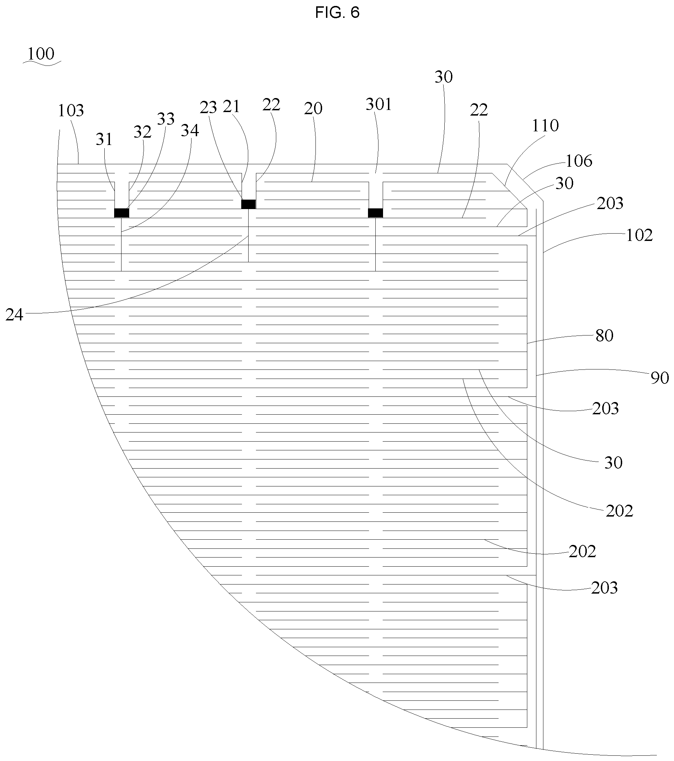

In addition, as shown in FIGS. 3 and 6, since only a portion of the first fingers 20 are connected to the fourth edge collecting grid line 90, during the subsequent soldering process the opposite-polarity solder ribbons (for example, the edge solder ribbons 220 described below), the solder ribbons intersect only a portion of the first fingers 20. As there are few intersection joints, insulating adhesive only needs to be applied at a limited number of discrete joints to prevent leakage, thereby effectively reducing costs. Moreover, the application joints of the insulating adhesive are isolated, making adhesive leakage less likely and thus preventing bending or warping of the solar cell. Moreover, the disposition of the third edge collecting grid line 80 enables the second fingers 30 to have a grid breakage prevention function, thereby minimizing the risk of grid breakage in the second fingers 30.

Optionally, in such an embodiment, the polarity of the third edge collecting grid line 80 at the second edge 102 is opposite to that of the first edge collecting grid line 40 at the first edge 101, with one being a positive electrode grid line and the other being a negative electrode grid line. The polarity of the fourth edge collecting grid line 90 at the second edge 102 is opposite to that of the second edge collecting grid line 50 at the first edge 101, with one being a positive electrode grid line and the other being a negative electrode grid line.

The second edge collecting grid line 50 is configured to collect the current from the second doped layers 13 in the edge region of the first edge 101, and the fourth edge collecting grid line 90 is configured to collect the current from the first doped layers 12 in the edge region of the second edge 102.

It is to be understood that, in such an embodiment, the structure and material of the third edge collecting grid line 80 are generally the same as those of the first edge collecting grid line 40, and the structure and material of the fourth edge collecting grid line 90 are generally the same as those of the second edge collecting grid line 50. Details are not described herein again.

As shown in FIG. 3, it is not difficult to understand that the fourth edge collecting grid line 90 is in contact with at least one of the first doped layer 12 to collect current from the first doped layer 12 in the edge region. Therefore, as shown in FIG. 6, in this embodiment, the number of the first disconnection regions 201 and the second disconnection regions 301 is even. Among the first disconnection regions 201 of the first fingers 20 and the second disconnection regions 301 of the second fingers 30, the second disconnection regions 301 are closest to the second edge 102. That is, in the second direction, the first disconnection region 201 and the second disconnection region 301 are alternately and sequentially arranged, and the disconnection region closest to the second edge 102 is the second disconnection region 301. At portions corresponding to the second disconnection regions 301, the first fingers 20 remain continuous, and solder ribbons in contact with the first fingers 20 may be disposed at such portions, to enable current convergence from the fourth edge collecting grid line 90.

### Embodiment 9

Referring to FIGS. 3 and 6, in some embodiments, a portion of the first fingers 20 pass through the third edge collecting grid line 80 in an insulated manner and are connected to the fourth edge collecting grid line 90.

In this way, after collecting the current in the edge region, the fourth edge collecting grid line 90 can converge current via the first finger 20, which passes through the third edge collecting grid line 80, to the nearest same-polarity solder ribbon, thereby enabling current collection.

Optionally, as shown in FIG. 6, in such an embodiment, the plurality of first fingers 20 may include a plurality of second collecting fingers 202 and a plurality of second through fingers 203. The plurality of second collecting fingers 202 are all disposed on the side of the third edge collecting grid line 80 facing the first edge 101, while the second through fingers 203 pass through the third edge collecting grid line 80 in an insulated manner and are connected to the fourth edge collecting grid line 90.

That is to say, in such an embodiment, no second collecting fingers 202 are provided between the third edge collecting grid line 80 and the second edge 102. Only at the portions where the second edge collecting grid line 50 is passed through are second through fingers 203 provided. No other grid lines (including the first fingers 20 and the second fingers 30) are present in the remaining portions between the third edge collecting grid line 80 and the second edge 102.

It is to be noted that, in the embodiments of the present disclosure, "a portion of the first fingers 20 pass through the third edge collecting grid line 80 in an insulated manner" can be understood as that in the first direction, the third edge collecting grid line 80 includes a plurality of spaced disconnection regions, and the second through fingers 203 pass through the third edge collecting grid line 80 via the disconnection regions without contacting the first edge collecting grid line 80, thereby achieving physical through-extension and electrical insulation.

It is to be understood that in such an embodiment, the number of second through fingers 203 may be one or more, and the specific number may be determined according to the size of the solar cell. When the number of the second through fingers 203 is more than one, the plurality of second through fingers 203 may be spaced apart along the first direction. The distance between two adjacent second through fingers 203 may be determined according to the size of the solar cell. Optionally, the second through fingers are uniformly spaced along the first direction on the silicon substrate 10 according to the length of the silicon substrate 10, which is not specifically limited herein.

It is not difficult to understand that, in such an embodiment, the fourth edge collecting grid line 90 can collect the current from the first doped layers 12 in the edge region of the second edge 102, and then converge the current via the second through fingers 203, which penetrate the third edge collecting grid line 80, to the nearest same-polarity solder ribbon (for example, the solder ribbon 210 described below), thereby enabling current convergence. By disposing a plurality of second through fingers 203, the current convergence path can be effectively shortened, thereby reducing power loss.

### Embodiment 10

Referring to FIGS. 3 and 6, in some embodiments, the third edge 103 is connected to the second edge 102 via a second chamfer 106.

In a direction from the third edge 103 toward the fourth edge 104, the second finger 30 and the first finger 20 are alternately and sequentially arranged, and a third auxiliary grid line 110 is disposed at the second chamfer 106, the third auxiliary grid line 110 connecting the second fingers 30 disposed at the second chamfer 106 to the third edge collecting grid line 80. It is to be noted that "the second fingers 30 disposed at the second chamfer 106" refers to those among the plurality of second fingers 30 that are not directly connected to the third edge collecting grid line 80 and intersect the second chamfer 106 along the extension lines in the second direction, for example, the uppermost two second fingers 30 in FIG. 4.

In this way, by disposing the third auxiliary grid line 110, the second fingers 30 at the second chamfer 106 can be connected to each other, thereby enabling conduction among the second fingers 30 at the second chamfer 106. During the subsequent soldering of solder ribbons (for example, the edge solder ribbons 220 described below), it is only necessary to bring the solder ribbon into contact with the third auxiliary grid line 110 to achieve current collection from the second fingers 30 at the second chamfer 106. This can prevent the issue where, during the subsequent soldering of the solder ribbons, due to the presence of the second chamfer 106, the solder ribbons fail to contact all of the second fingers 30 at the second chamfer 106, resulting in unsuccessful current collection from the second fingers 30 at the second chamfer 106.

Optionally, as shown in FIG. 6, in such an embodiment, the third auxiliary grid line 110 may be disposed in parallel with the second chamfer 106. This arrangement can simplify the fabrication of the grid line structure on the back side 11.

As shown in FIG. 6, it is not difficult to understand that, since the second fingers 30 include second disconnection regions 301 at the portions closest to the second edge 102, to enable current convergence of the second fingers 30 near the second edge 102, solder ribbons need to be disposed at the second edge 102 to establish electrical connection with the second fingers 30 for current convergence. However, due to the presence of the second chamfer 106, the uppermost second fingers 30 are relatively short. When the solder ribbon is vertically disposed, it cannot make contact with the uppermost second fingers 30. If the solder ribbon is disposed too far inward, it may easily come into contact with the opposite-polarity first fingers 20, resulting in leakage. Therefore, by disposing the third auxiliary grid line 110, the second fingers 30 at the second chamfer 106 can be interconnected as a whole. During the soldering of the solder ribbons, it is only necessary to make the solder ribbons in contact with the third edge collecting grid line 80, or simultaneously in contact with both the third edge collecting grid line 80 and the third auxiliary grid line 110, or in contact with other second fingers 30 connected to the third edge collecting grid line 80 and the third auxiliary grid line 110, to achieve current convergence from all of the second fingers 30.

### Embodiment 11

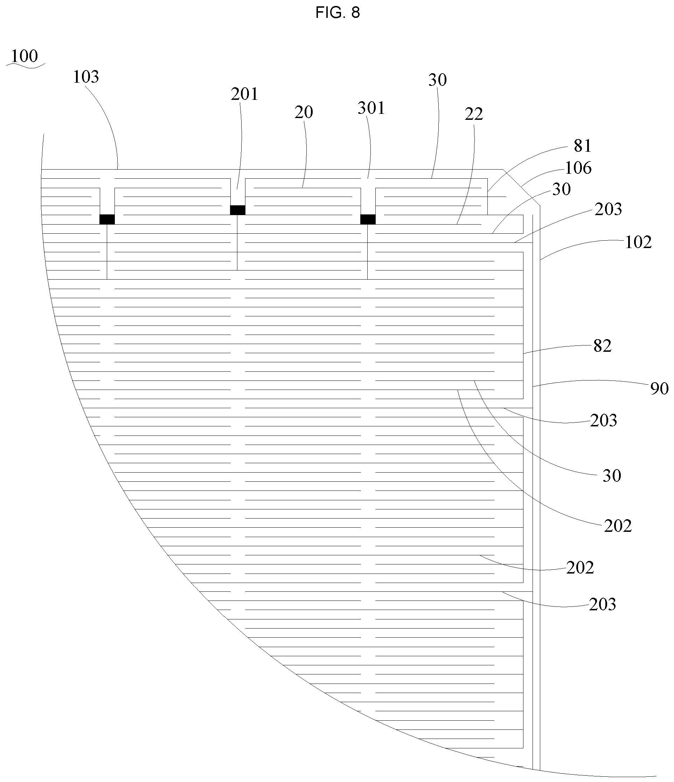

Referring to FIG. 8, in some embodiments, the third edge collecting grid line 80 may include a first collecting grid line segment 81 and a second collecting grid line segment 82. The first collecting grid line segment 81 is connected to the second fingers 30 disposed at the second chamfer 106. Similarly, in such an embodiment, "the second fingers 30 disposed at the second chamfer 106" refers to those among the plurality of second fingers 30 that are not directly connected to the third edge collecting grid line 80 and intersect the second chamfer 106 along the extension lines in the second direction, for example, the uppermost two second fingers 30 in FIG. 8. The second collecting grid line segment 82 is connected to the second fingers 30 except those disposed at the second chamfer 106. It is to be understood that, as shown in FIG. 8, in such an embodiment, due to the presence of the second through fingers 203, the second collecting grid line segment 82 has a discontinuous structure.

In this way, the first collecting grid line segment 81 can connect the second fingers 30 at the second chamfer 106 into an integrated unit. When disposing the solder ribbons, to achieve current convergence for the second fingers 30 at the second chamfer 106, it is only necessary for the solder ribbon to contact any one of the second fingers 30 at the second chamfer 106, thereby enabling current convergence for all the second fingers 30 at the second chamfer 106.

Optionally, as shown in FIG. 8, in such an embodiment, the first collecting grid line segment 81 and the second collecting grid line segment 82 are spaced apart along the second direction, and the second collecting grid line segment 82 are closer to the second edge 102 compared to the first collecting grid line segment 81.

Optionally, in such an embodiment, the top end of the first collecting grid line segment 81 may be connected to the end of the topmost second finger 30 and extend along the first direction, thereby allowing all the second fingers 30 at the second chamfer 106 to be connected as an integrated whole.

It is not difficult to understand that the difference between this embodiment and Embodiment 10 above only in that, in Embodiment 10, the second fingers 30 at the second chamfer 106 are connected as an integrated whole by disposing a third auxiliary grid line 110 in parallel with the second chamfer 106, whereas in this embodiment, the second fingers 30 at the second chamfer 106 are connected as an integrated whole via the first collecting grid line segment 81. Both approaches may also be employed simultaneously, which is not specifically limited herein.

### Embodiment 12

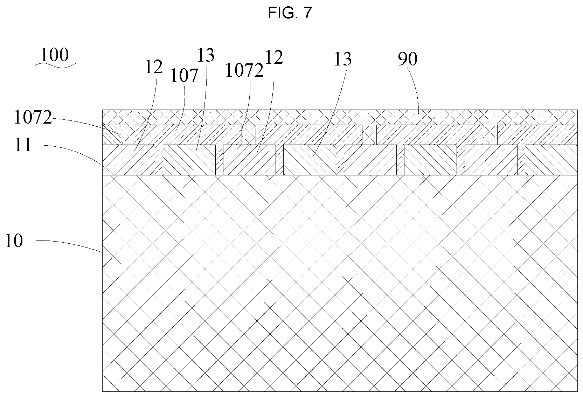

Referring to FIG. 7, a passivation film layer 107 is disposed on the first doped layers 12 and the second doped layers 13. The fourth edge collecting grid line 90 is disposed on the passivation film layer 107. In the region corresponding to the fourth edge collecting grid line 90 (the projection region of the fourth edge collecting grid line 90 on the passivation film layer 107), second openings 1072 are formed at the portions of the passivation film layer 107 corresponding to the first doped layer 12, such that the fourth edge collecting grid line 90 is in contact with the first doped layer 12 via the second openings 1072.

In this way, by forming the second openings 1072 at the portions of the passivation film layer 107 corresponding to the first doped layers 12, the fourth edge collecting grid line 90 can be brought into stable contact with the first doped layers 12 under the edge region during printing to enable current collection, while also preventing the fourth edge collecting grid line 90 from coming into contact with the second doped layers 13, which would otherwise cause current leakage.

Optionally, in such an embodiment, the second openings 1072 may be formed in the passivation film layer 107 by laser ablation. To achieve maximum current collection, the second openings 1072 can be formed over all of the first doped layers 12, so that the fourth edge collecting grid line 90 is in contact with all of the first doped layers 12 via the second openings 1072, thereby enabling maximum current collection. In some embodiments, the second openings 1072 may also be formed on a portion of the first doped layers 12, which is not specifically limited herein.

### Embodiment 13

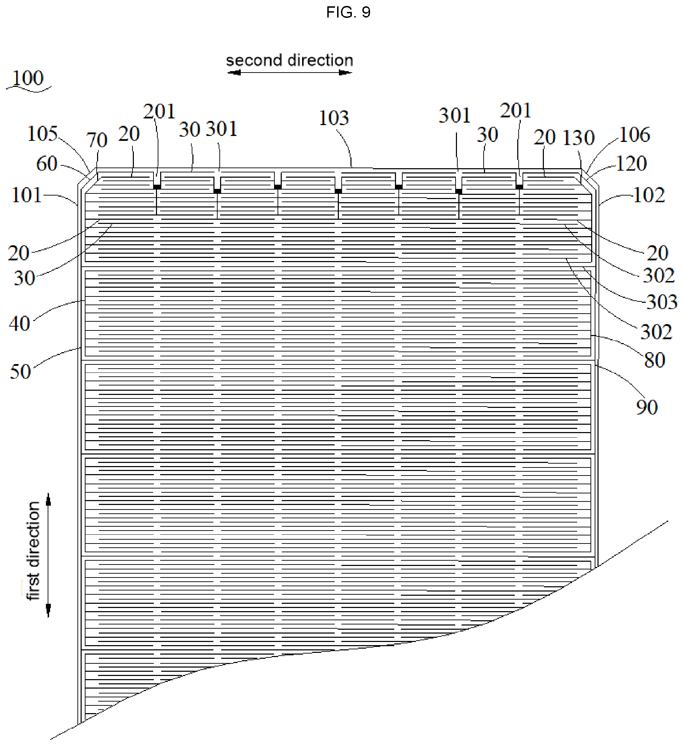

Referring to FIG. 9, in some embodiments, the third edge collecting grid line 80 may also be electrically connected to the first fingers 20, the first fingers 20 do not extend to the second edge 102 of the silicon substrate 10, and the polarity of the third edge collecting grid line 80 is the same as that of the first edge collecting grid line 40.

Moreover, in such an embodiment, the polarity of the fourth edge collecting grid line 90 is the same as that of the second edge collecting grid line 50, and the forth edge collecting grid line 90 is in contact with at least one of the second doped layers 13 and are electrically connected to ends of a portion of second fingers 30 close to the second edge 102.

In such an embodiment, the difference from the example shown in FIG. 3 lies in that, in the example shown in FIG. 9, the polarity of the third edge collecting grid line 80 is the same as that of the first edge collecting grid line 40, and the polarity of the fourth edge collecting grid line 90 is the same as that of the second edge collecting grid line 50; whereas in the example shown in FIG. 3, the polarity of the third edge collecting grid line 80 is opposite to that of the first edge collecting grid line 40, and the polarity of the fourth edge collecting grid line 90 is opposite to that of the second edge collecting grid line 50.

Optionally, in such an embodiment, the third edge collecting grid line 80 and the fourth edge collecting grid line 90 at the second edge 102 are symmetrically disposed with respect to the first edge collecting grid line 40 and the second edge collecting grid line 50 at the first edge 101, and all their structures are the same as those at the first edge 101. The number of the first disconnection regions 201 and the second disconnection regions 301 is odd.

It is to be understood that, in such an embodiment, the structure and material of the third edge collecting grid line 80 are generally the same as those of the first edge collecting grid line 40, and the structure and material of the fourth edge collecting grid line 90 are generally the same as those of the second edge collecting grid line 50. Details are not described herein again.

Similarly, as shown in FIG. 9, it is not difficult to understand that the fourth edge collecting grid line 90 is in contact with the second doped layers 13 to collect current from the second doped layers 13 in the edge region at the second edge 102. Therefore, as shown in FIG. 9, in this embodiment, among the first disconnection regions 201 of the first fingers 20 and the second disconnection regions 301 of the second fingers 30, the first disconnection regions 201 are closest to the second edge 102. That is, in the second direction, the first disconnection region 201 and the second disconnection region 301 are alternately and sequentially arranged, and the disconnection region closest to the second edge 102 is the first disconnection region 201. At regions corresponding to the first disconnection regions 201, the second fingers 30 remain continuous, and solder joints in contact with the second grid lines 30 may be disposed at such regions, to enable current convergence from the third edge collecting grid line 80.

### Embodiment 14

Referring to FIG. 9, in some embodiments, a portion of the second fingers 30 pass through the third edge collecting grid line 80 in an insulated manner and are electrically connected to the fourth edge collecting grid line 90.

In this way, after collecting the current in the edge region of the second edge 102, the fourth edge collecting grid line 90 may converge current via the second fingers 30, which passes through the third edge collecting grid line 80, to the nearest same-polarity solder ribbon, thereby enabling current collection.

Optionally, as shown in FIG. 9, as described above, in such an embodiment, the plurality of second fingers 30 may include a plurality of first collecting fingers 302 and a plurality of first through fingers 303. On the basis of the second edge 102, the plurality of first collecting fingers 302 are all disposed on the side of the third edge collecting grid line 80 facing the first edge 101, while the first through fingers 303 pass through the third edge collecting grid line 80 in an insulated manner and are connected to the fourth edge collecting grid line 90.

That is to say, in such an embodiment, no first collecting fingers 302 are provided between the third edge collecting grid line 80 and the second edge 102. Only at the portions where the third edge collecting grid line 80 is passed through are first through fingers 303 provided between the fourth edge collecting grid line 90 and the second edge 102.

It is to be noted that, in the embodiments of the present disclosure, "a portion of the second fingers 30 pass through the third edge collecting grid line 80 in an insulated manner" can be understood as that in the first direction, the third edge collecting grid line 80 includes a plurality of spaced disconnection regions, and the first through fingers 303 pass through the third edge collecting grid line 80 via the disconnection regions without contacting the first edge collecting grid line 80, thereby achieving physical through-extension and electrical insulation.

Similarly, in such an embodiment, the number of first through fingers 303 may be one or more, and the specific number may be determined according to the size of the solar cell. When the number of the first through fingers 303 is more than one, the plurality of first through fingers 303 may be spaced apart along the first direction. The distance between two adjacent first through fingers 303 may be determined according to the size of the solar cell. Optionally, the first through fingers are uniformly spaced along the first direction on the silicon substrate 10 according to the length of the silicon substrate 10, which is not specifically limited herein.

It is to be noted that, in such an embodiment, the first through finger 303 that passes through the third edge collecting grid line 80 may or may not be the same grid line as the first through finger that passes through the first edge collecting grid line 40, which is not specifically limited herein. Optionally, they are the same grid line. When they are the same, a grid line structure at the first edge 101 is completely symmetrical with a grid line structure at the second edge 102.

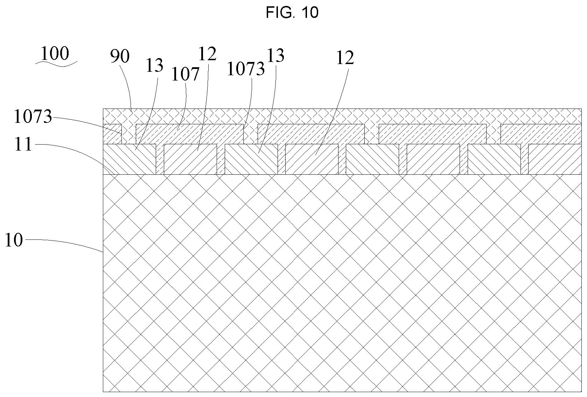

Referring to FIG. 10, in such an embodiment, in a region corresponding to the fourth edge collecting grid line 90 (the projection region of the fourth edge collecting grid line 90 on the passivation film layer 107), third openings 1073 are formed at the portions of the passivation film layer 107 corresponding to the second doped layers 13, such that the fourth edge collecting grid line 90 is in contact with the second doped layer 13 via the third opening 1073.

In this way, by forming the third openings 1073 at the portions of the passivation film layer 107 corresponding to the second doped layer 13, the fourth edge collecting grid line 90 can be brought into stable contact with the second doped layers 13 under the edge region during printing to enable current collection, while also preventing the fourth edge collecting grid line 90 from coming into contact with the first doped layers 12, which would otherwise cause current leakage.

Optionally, in such an embodiment, the structure of the fourth edge collecting grid line 90 and the third openings 1073 may be the same as the structure of the second edge collecting grid line 50 and the first openings 1071 described above, and the structures of the two may be symmetrical to each other. **In** this embodiment, and the third openings 1073 may be formed in the passivation film layer 107 by laser ablation. **To** achieve maximum current collection, the third openings 1073 can be formed over all of the second doped layers 13, so that the fourth edge collecting grid line 90 can in contact with all of the second doped layers 13 via the third openings 1073, thereby enabling maximum current collection. In some embodiments, the third openings 1073 may also be formed on a portion of the second doped layers 13, which is not specifically limited herein.

### Embodiment 15

Referring to FIG. 9. **In** some embodiments, the third edge 103 is connected to the second edge 102 via a second chamfer 106.

In a direction from the third edge 103 toward the fourth edge 104, the second finger 30 and the first finger 20 are alternately and sequentially arranged. A fourth auxiliary grid line 120 is disposed at the second chamfer 106, the fourth auxiliary grid line 120 connecting the fourth edge collecting grid line 90 to the second fingers 30 closest to the third edge 103.

In this way, by disposing a fourth auxiliary grid line 120 at the second chamfer 106, the current collected by the fourth edge collecting grid line 90 can be converged to the second finger 30 at the third edge 103, and then further converged to the nearest solder ribbon.

Optionally, as shown in FIG. 9, the third edge 103 is a top edge of the silicon substrate 10, and the fourth edge 104 is a bottom edge of the silicon substrate 10. The first edge 101 and the third edge 103 form a first chamfer 105, and the second edge 102 and the third edge 103 form a second chamfer 106.

As shown in FIG. 9, in such an embodiment, the first chamfer 105 is symmetrically arranged with respect to the second chamfer 106, and the fourth auxiliary grid line 120 is symmetrically arranged with respect to the first auxiliary grid line 60.

It is to be understood that, in such an embodiment, the first through fingers 303 and the third auxiliary grid line 110 described above may be provided together to achieve current convergence, or the first through fingers 303 described above may be omitted, and the current convergence may instead be achieved via the fourth auxiliary grid line 120 at the second chamfer 106. To avoid excessive losses caused by an overly long current convergence path, current convergence may be achieved via the first through fingers 303 alone or jointly via the first through fingers 303 and the fourth auxiliary grid line 120, which is not limited herein.

In some embodiments, the fourth auxiliary grid line 120 is disposed in parallel with the second chamfer 106. This arrangement can simplify the fabrication of the grid line structure on the back side 11.

In some embodiments, the fourth auxiliary grid line 120 may be disposed above at least one of the second doped layers 13 and in contact with at least one of the second doped layers 13.

In this way, the fourth auxiliary grid line 120 can not only achieve current convergence, but also collect the current in the edge region at the second chamfer 106, thereby further reducing efficiency loss and improving the efficiency of the solar cell.

Referring to FIG. 9, in some embodiments, a fifth auxiliary grid line 130 may be further disposed at the first chamfer 105, and the fifth auxiliary grid line 130 connects the first finger 20 disposed at the second chamfer 106 to the third edge collecting grid line 80. Similarly, it is to be noted that "the second fingers 30 disposed at the second chamfer 106" refers to those among the plurality of second fingers 30 that are not directly connected to the third edge collecting grid line 80 and intersect the second chamfer 106 along the extension lines in the second direction, for example, the uppermost two second fingers 30 in FIG. 7.

In this way, by disposing the fifth auxiliary grid line 130, the first fingers 20 at the second chamfer 106 can be connected to each other, thereby enabling conduction among the first fingers 20 at the second chamfer 106. During the subsequent soldering of solder ribbons, it is only necessary to bring the solder ribbon into contact with the fifth auxiliary grid line 130 to achieve current collection from the first fingers 20 at the second chamfer 106. This can prevent the issue where, during subsequent soldering the solder ribbons 210, due to the presence of the second chamfer 106, the solder ribbon 210 fail to contact all of the first fingers 20 at the second chamfer 106, resulting in unsuccessful current collection from the first fingers 20 at the second chamfer 106.

Optionally, as shown in FIG. 9, in such an embodiment, the fifth auxiliary grid line 130 may also be disposed in parallel with the second chamfer 106. That is, at the second chamfer 106, from the outer side to the inner side, the second chamfer 106, the fourth auxiliary grid line 120, and the fifth auxiliary grid line 130 are sequentially disposed in parallel, and the fifth auxiliary grid line 130 is symmetrically disposed with respect to the second auxiliary grid line 70.

### Embodiment 16

In some embodiments, the distance between the third edge collecting grid line 80 and the second edge 102 (their spacing in the second direction) is 0.5 mm to 2 mm.

In this way, by setting the spacing between the third edge collecting grid line 80 and the second edge 102 within this reasonable range, it is possible to effectively avoid excessive distance that may result in an overly large area in the edge region without fingers, which would otherwise lead to significant efficiency loss, and also to avoid too small a distance that could lead to poor soldering or wafer chipping during subsequent soldering of the solder ribbon at the third edge collecting grid line 80, thereby ensuring reliability and stability of soldering.

Optionally, in such an embodiment, the distance between the third edge collecting grid line 80 and the second edge 102 may be, for example, 0.5 mm, 0.6 mm, 0.7 mm, 0.8 mm, 0.9 mm, 1 mm, 1.2 mm, 1.4 mm, 1.6 mm, 1.8 mm, 2 mm, or any value within the range from 0.5 mm to 2 mm, which is not specifically limited herein.

In the embodiments of the present disclosure, the distance between the third edge collecting grid line 80 and the second edge 102 may be 0.8 mm to 1.2 mm, for example, 0.9 mm. This configuration can reduce process complexity while effectively preventing excessive distance that may result in an overly large area in the edge region without fingers, which would otherwise lead to significant efficiency loss. Moreover, it ensures the stability and reliability of soldering.

### Embodiment 17

In some embodiments, the distance between the fourth edge collecting grid line 90 and the second edge 102 (their spacing in the second direction) is 0.3 mm to 1.2 mm.

In this way, in one aspect, it can prevent the distance between the fourth edge collecting grid line 90 and the second edge 102 from too small, which would significantly increase the printing difficulty of the fourth edge collecting grid line 90, and in another aspect, it can also avoid excessive distance between the fourth edge collecting grid line 90 and the second edge 102 that may result in an overly large area in the edge region without fingers, which would otherwise lead to significant efficiency loss.

Optionally, in such an embodiment, the distance between the fourth edge collecting grid line 90 and the second edge 102 may be, for example, 0.3 mm, 0.4 mm, 0.5 mm, 0.6 mm, 0.7 mm, 0.8 mm, 0.9 mm, 1 mm, 1.2 mm, or any value within the range from 0.3 mm to 1.2 mm, which is not specifically limited herein.

In the embodiments of the present disclosure, the distance between the fourth edge collecting grid line 90 and the second edge 102 may be 0.3 mm to 0.6 mm, for example, 0.5 mm. This configuration can reduce process complexity while effectively preventing excessive distance that may result in an overly large area in the edge region without fingers, which would otherwise lead to significant efficiency loss. That is, it can reduce the printing difficulty while preventing significant efficiency loss.

### Embodiment 18

In some embodiments, the width of the fourth edge collecting grid line 90 is 20 um to 200 um.

In this way, by setting the width of the fourth edge collecting grid line 90 within this reasonable range, it is possible to avoid the occurrence of fusing during current convergence due to insufficient current-carrying capacity caused by an excessively small width of the fourth edge collecting grid line 90, and also to avoid a significant increase in cost due to an excessively large width of the fourth edge collecting grid line 90.

Optionally, in such an embodiment, the width of the fourth edge collecting grid line 90 may be, for example, 20 um, 30 um, 40 um, 50 um, 60 um, 70 um, 80 um, 90 um, 100 um, 110 um, 120 um, 130 um, 140 um, 150 um, 160 um, 170 um, 180 um, 190 um, 200 um, or any value within the range from 20 um to 200 um, which is not specifically limited herein.

In some embodiments, the width of the fourth edge collecting grid line 90 is greater than the width of the third edge collecting grid line 80.

In this way, since the fourth edge collecting grid line 90 serves to collect the current from the second doped layers 13 in the edge region and thus functions in both current collection and current convergence, configuring the width of the fourth edge collecting grid line 90 to be greater than that of the third edge collecting grid line 80 can enhance the current-carrying capacity of the fourth edge collecting grid line 90, thereby ensuring the stability of the solar cell.

### Embodiment 19

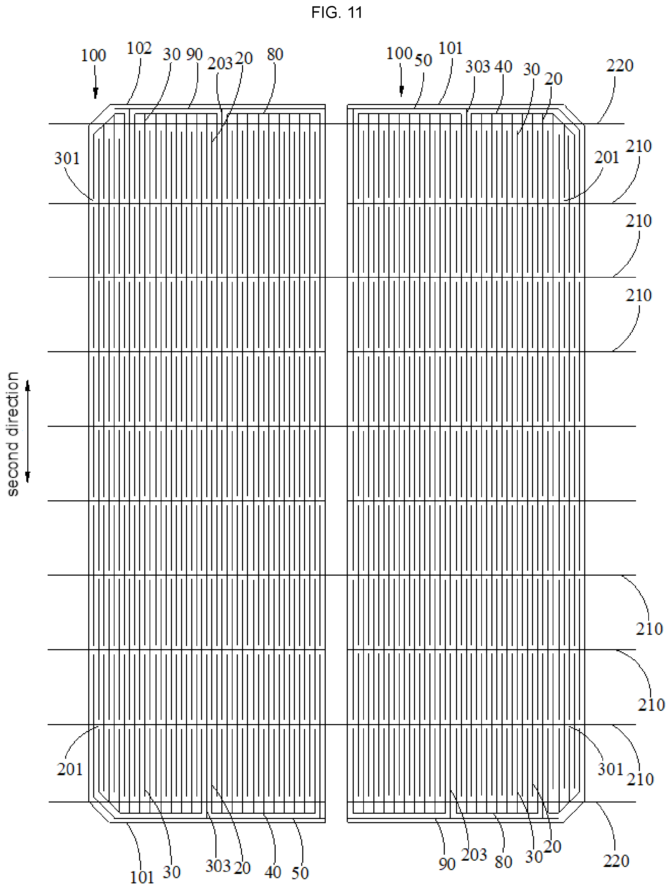

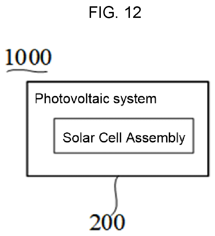

Referring to FIGS. 11 and 12, the present disclosure further provides a photovoltaic system 1000. The photovoltaic system 1000 may include a solar cell assembly 200 in the embodiments of the present disclosure. The solar cell assembly 200 in the embodiments of the present disclosure may include a plurality of IBC solar cells 100 according to the embodiments of the present disclosure. In some embodiments, the plurality of IBC solar cells 100 in the solar cell assembly 200 may be sequentially connected in series to form a cell string. The cell strings may be connected in series, in parallel, or in a series-parallel combination to achieve current convergence and output. For example, the connection between the solar cells may be implemented through the soldering of the solder ribbons (comprising the solder ribbons 210 and edge solder ribbons 220 described below), and the connection between the cell strings may be implemented via busbars.

It is to be understood that the IBC solar cell 100 in the embodiments of the present disclosure may be a full cell or a half cell, which is not specifically limited herein.

As shown in FIG. 11, in two adjacent IBC solar cells 100, the first disconnection region 201 of one IBC solar cell 100 corresponds to the second disconnection region 301 of the other IBC solar cell 100 in the first direction. A solder ribbon 210 is disposed at the first disconnection region 201 and the second disconnection region 301, and each first disconnection region 201 and each second disconnection region 301 is correspondingly provided with one solder ribbon 210.

In two adjacent IBC solar cells 100, the first finger 20 of one IBC solar cell 100 is connected to the solder ribbon 210 at the first disconnection region 201, and the second finger 30 of the other IBC solar cell 100 is connected to the solder ribbon 210 at the second disconnection region 301. That is, the solder ribbon 210 at the first disconnection region 201 can be soldered to the solar cell via the first end solder joint 23 and the second end solder joint 27 as described above. The solder ribbon 210 is in contact with the second finger 30 that is not connected to the first connecting grid line 21, the second connecting grid line 22, the fourth connecting grid line 25, or the fifth connecting grid line 26. The solder ribbon 210 at the second disconnection region 301 can be soldered to the solar cell via the third end solder joint 33 and the fourth end solder joint 37 as described above. The solder ribbon 210 is in contact with the first finger 20 that is not connected to the seventh connecting grid line 31, the eighth connecting grid line 32, the tenth connecting grid line 35, or the eleventh connecting grid line 36.

In the cell string of the embodiments of the present disclosure, the following types of connections are available:
As shown in FIG. 11, in two adjacent IBC solar cells 100, the first edge 101 includes a first edge collecting grid line 40 and a second edge collecting grid line 50, while the second edge 102 includes a third edge collecting grid line 80 and a fourth edge collecting grid line 90. The polarity of the first edge collecting grid line 40 is opposite to that of the third edge collecting grid line 80, and the polarity of the second edge collecting grid line 50 is opposite to that of the fourth edge collecting grid line 90.

In the cell string, in two adjacent IBC solar cells 100, the first edge 101 of one IBC solar cell 100 is aligned with the second edge 102 of the other, such that the first edge collecting grid line 40 and the third edge collecting grid line 80 of the two solar cells are correspondingly disposed on the same side, and the second edge collecting grid line 50 and the fourth edge collecting grid line 90 are disposed on the same side. The central regions of the two IBC solar cells 100 are connected via solder ribbons 210, while the edge regions are connected in series by soldering together edge solder ribbons 220 disposed at the first edge 101 and the second edge 102. It is only necessary to apply insulating adhesive to the edge solder ribbons 220 at positions where they are in contact with grid lines of different polarities (for example, the first through finger 303 and the second through finger 203 in FIG. 11). As shown in FIG. 8, the edge solder ribbons 220 are electrically connected to the first edge collecting grid line 40 and the third edge collecting grid line 80 that are disposed on the same side. The edge solder ribbons 220 may be disposed along the first direction and may be soldered to the first edge collecting grid line 40 and the third edge collecting grid line 80, or to the first fingers 20 and the second fingers 30.

2. In two adjacent IBC solar cells 100, only the first edge 101 includes a first edge collecting grid line 40 and a second edge collecting grid line 50.

In this case, in the two adjacent IBC solar cells 100, the polarities of two first edge collecting grid line 40 disposed on the same side are opposite, and the polarities of two first fingers connected to the different first edge collecting grid lines 40 also are opposite. The polarities of two second edge collecting grid lines 50 are also opposite. That is, in the two adjacent IBC solar cells 100, the first edge collecting grid line 40 of one IBC solar cell 100 is a P-type grid line, while the first edge collecting grid line 40 of the other is an N-type grid line. The two IBC solar cells 100 are connected in series by soldering via a solder ribbon disposed at the first edge 101.

As shown in FIG. 11, in some embodiments, in the cell string, the edge solder ribbon 220 may be directly connected to the first edge collecting grid line 40 and the third edge collecting grid line 80 by soldering, either by contact or by overlap. Certainly, in some embodiments, the edge solder ribbon 220 may also be disposed on the inner side of the first edge collecting grid line 40 and the third edge collecting grid line 80 (i.e., on the side of the first edge collecting grid line 40 facing away from the first edge 101). In two adjacent IBC solar cells 100, the edge solder ribbon 220 is soldered to the first finger 20 in one IBC solar cell 100, and the edge solder ribbon 220 is soldered to the second finger 30 in the other IBC solar cell 100.

3. In the IBC solar cell 100, the first edge collecting grid line 40, the second edge collecting grid line 50, the third edge collecting grid line 80, and the fourth edge collecting grid line 90 are not provided. In this case, the cell strings are connected in a conventional series manner. Details are not described herein again.

In the description of this specification, descriptions with reference to the terms "some embodiments", "illustrative embodiments", "examples", "specific examples", or "some examples", etc. mean that specific features, structures, materials, or characteristics described in connection with the embodiment or example are included in at least one embodiment or example of the present disclosure. In this description, the illustrative expressions of the terms above do not necessarily refer to the same embodiment or example. Optionally, the specific features, structures, materials, or characteristics described may be combined in a suitable manner in any one or more embodiments or examples.

In addition, the embodiments described above are only preferred embodiments of the present disclosure, and are not intended to limit the present disclosure. Any modifications, equivalent replacements, improvements, and the like made within the spirit and principle of the present disclosure are to be included in the protection scope of the present disclosure.

## Claims

1. A zero-busbar electrode structure for an IBC solar cell, wherein the zero-busbar electrode structure is disposed on a back side of a silicon substrate of the IBC solar cell, and the zero-busbar electrode structure comprises:
a plurality of first fingers and a plurality of second fingers, wherein the plurality of first fingers and the plurality of second fingers are alternately and sequentially spaced apart along a first direction and each of which extends along a second direction, and the second direction intersecting the first direction; in the second direction, the silicon substrate comprises a first edge and a second edge opposite to each other; in the first direction, the silicon substrate comprises a third edge and a fourth edge opposite to each other;
in the second direction, the first fingers comprise a plurality of spaced first disconnection regions and the second fingers comprise a plurality of spaced second disconnection regions, wherein the first disconnection region and the second disconnection region are alternately and sequentially spaced apart; the first disconnection regions on adjacent first fingers correspond to each other in the first direction, and the second disconnection regions on adjacent second fingers correspond to each other in the first direction; and
first end solder joints disposed close to the third edge and disposed at the first disconnection regions, wherein the first end solder joints are all not in contact with the first fingers and are all electrically connected to a portion of the second fingers closest to the third edge.

2. The zero-busbar electrode structure according to claim 1, wherein the zero-busbar electrode structure further comprises:
first connecting grid lines and second connecting grid lines disposed at the first disconnection regions, wherein the first connecting grid line and the second connecting grid line are spaced apart along the second direction and each of which extends along the first direction, and the first connecting grid lines and the second connecting grid lines are all not in contact with the first fingers, and the first connecting grid lines and the second connecting grid lines are connected to a portion of the second fingers closest to the third edge.

3. The zero-busbar electrode structure according to claim 2, wherein in the first direction, a distance between each of the first end solder joints and the third edge is 1 cm to 3 cm.

4. The zero-busbar electrode structure according to claim 2, wherein each of the first connecting grid lines and each of the second connecting grid lines are both connected to at least three second fingers; and/or
in the first direction, a length of each of the first connecting grid lines and a length of each of the second connecting grid lines are both at least four times spacing between the first finger and the second finger.

5. **The** zero-busbar electrode structure according to claim 2, wherein the zero-busbar electrode structure further comprises third connecting grid lines, and the third connecting grid lines are disposed at the first disconnection regions and are not in contact with the first fingers, and each of the third connecting grid lines is connected to one of the first end solder joints and to a portion of the second fingers between the first connecting grid line and the second connecting grid line and the fourth edge.

6. **The** zero-busbar electrode structure according to claim 2, wherein the zero-busbar electrode structure further comprises fourth connecting grid lines and fifth connecting grid lines disposed at the first disconnection regions, the fourth connecting grid lines and the fifth connecting grid lines being spaced apart along the second direction and each of which extending along the first direction, and the fourth connecting grid lines and the fifth connecting grid lines are all not in contact with the first fingers and are all connected to a portion of the second fingers closest to the fourth edge; and
second end solder joints disposed close to the fourth edge and disposed at the first disconnection regions, each of the second end solder joints being disposed between one of the fourth connecting grid lines and one of the fifth connecting grid lines and is in contact with the fourth connecting grid line and the fifth connecting grid line.

7. **The** zero-busbar electrode structure according to claim 6, wherein in the first direction, a distance between each of the second end solder joints and the fourth edge is 1 cm to 3 cm.

8. **The** zero-busbar electrode structure according to claim 6, wherein the zero-busbar electrode structure further comprises sixth connecting grid lines, the sixth connecting grid lines being disposed at the first disconnection regions, and each of the sixth connecting grid lines being connected to one of the second end solder joints and to a portion of the second fingers that between the first connecting grid line and the second connecting grid line and the third edge.

9. **The** zero-busbar electrode structure according to claim 6, further comprising seventh connecting grid lines and eighth connecting grid lines disposed at the second disconnection regions, wherein the seventh connecting grid line and the eighth connecting grid line are spaced apart along the second direction and each of which extends along the first direction, and the seventh connecting grid lines and the eighth connecting grid lines are not in contact with the second fingers and are connected to a portion of the first fingers closest to the third edge; and
third end solder joints disposed close to the third edge and disposed at the second disconnection regions, wherein each of the third end solder joints is disposed between one of the seventh connecting grid lines and one of the eighth connecting grid line and is in contact with the seventh connecting grid lines and the eighth connecting grid lines.

10. **The** zero-busbar electrode structure according to claim 9, wherein in the first direction, a distance between each of the third end solder joints and the third edge is 1 cm to 3 cm.

11. **The** zero-busbar electrode structure according to claim 9, wherein each of the seventh connecting grid lines and each of the eighth connecting grid lines are both connected to at least three first fingers; and/or
in the first direction, a length of each of the seventh connecting grid line and a length of each of the eighth connecting grid line are both at least four times spacing between the first finger and the second finger.

12. **The** zero-busbar electrode structure according to claim 9, wherein the zero-busbar electrode structure further comprises ninth connecting grid lines, the ninth connecting grid lines being disposed at the second disconnection regions, and each of the ninth connecting grid lines is connected to one of the third end solder joints and to a portion of the first fingers that between the seventh connecting grid lines and the fourth edge and that between the eighth connecting grid lines and the fourth edge.

13. **The** zero-busbar electrode structure according to claim 9, wherein the zero-busbar electrode structure further comprises tenth connecting grid lines and eleventh connecting grid lines disposed at the second disconnection regions, the tenth connecting grid line and the eleventh connecting grid line being spaced apart along the second direction and each of which extending along the first direction, and the tenth connecting grid lines and the eleventh connecting grid lines are not in contact with the second fingers, and the tenth connecting grid lines and the eleventh connecting grid lines are connected to a portion of the first fingers closest to the fourth edge; and
fourth end solder joints disposed close to the fourth edge and disposed at the second disconnection regions, each of the fourth end solder joints being disposed between one of the tenth connecting grid lines and one of the eleventh connecting grid lines and is in contact with the tenth connecting grid line and the eleventh connecting grid line.

14. **The** zero-busbar electrode structure according to claim 13, wherein in the first direction, a distance between each of the fourth end solder joints and the fourth edge is 1 cm to 3 cm.

15. **The** zero-busbar electrode structure according to claim 13, wherein the zero-busbar electrode structure further comprises twelfth connecting grid lines, the twelfth connecting grid lines being disposed at the first disconnection regions, and each of the twelfth connecting grid lines being connected to one of the fourth end solder joints and to a portion of the first fingers that between the first connecting grid lines and the third edge and the second connecting grid lines and the third edge.

16. **The** zero-busbar electrode structure according to claim 2, wherein a plurality of first doped layers and a plurality of second doped layers are disposed on the back side of the silicon substrate, the plurality of first doped layers and the plurality of second doped layers being alternately and sequentially arranged along the first direction and each of which extending along the second direction, and the first direction intersecting the second direction; the first fingers are disposed above the first doped layers, and the second fingers are disposed above the second doped layers, and the first fingers do not extend to the first edge of the silicon substrate; and
the zero-busbar electrode structure further comprises:
a first edge collecting grid line disposed close to the first edge and extends along the first direction, and the first edge collecting grid line is electrically connected to the first fingers; and
a second edge collecting grid line extending along the first direction, wherein the second edge collecting grid line is disposed between the first edge collecting grid lines and the first edge and disposed above the second doped layers, and the second edge collecting grid line is in contact with at least one of the second doped layers and electrically connected to ends of a portion of the second fingers close to the first edge.

17. **The** zero-busbar electrode structure according to claim 16, wherein a portion of the second fingers pass through the first edge collecting grid line in an insulated manner and are electrically connected to the second edge collecting grid line.

18. **The** zero-busbar electrode structure according to claim 16, wherein the third edge is connected to the first edge via a first chamfer; and
in a direction from the third edge toward the fourth edge, the second finger and the first finger are alternately and sequentially arranged, and a first auxiliary grid line is disposed at the first chamfer, the first auxiliary grid line connecting the second edge collecting grid line to a second finger closest to the third edge.

19. **The** zero-busbar electrode structure according to claim 16, wherein the zero-busbar electrode structure further comprises:
a third edge collecting grid line disposed close to the second edge and extends along the first direction, wherein the third edge collecting grid line is electrically connected to the second fingers, and the second fingers do not extend to the second edge, and a polarity of the third edge collecting grid line is opposite to that of the first edge collecting grid lines; and
a fourth edge collecting grid line extending along the first direction, wherein the fourth edge collecting grid line is disposed between the third edge collecting grid line and the second edge and above the first doped layers, and the fourth edge collecting grid line is in contact with at least one of the first doped layers and electrically connected to ends of a portion of the first fingers close to the second edge.

20. **The** zero-busbar electrode structure according to claim 19, wherein a portion of the first fingers pass through the third edge collecting grid line in an insulated manner and are connected to the fourth edge collecting grid line.

21. **The** zero-busbar electrode structure according to claim 19, wherein the third edge is connected to the second edge via a second chamfer; and
in a direction from the third edge toward the fourth edge, the second finger and the first finger are alternately and sequentially arranged, and a third auxiliary grid line is disposed at the second chamfer, the third auxiliary grid line connecting the second fingers disposed at the second chamfer to the third edge collecting grid line.

22. **The** zero-busbar electrode structure according to claim 16, the zero-busbar electrode structure further comprises:
a third edge collecting grid line disposed close to the second edge and extends along the first direction, wherein the third edge collecting grid line is electrically connected to the first fingers, the first fingers do not extend to the second edge of the silicon substrate, and a polarity of the third edge collecting grid line is the same as that of the first edge collecting grid line; and
a fourth edge collecting grid line disposed close to the second edge extending along the first direction, wherein the fourth edge collecting grid line is disposed between the third edge collecting grid lines and the second edge and disposed above the second doped layers, and the fourth edge collecting grid line is in contact with at least one of the second doped layers and electrically connected to ends of a portion of the second fingers close to the second edge.

23. **The** zero-busbar electrode structure according to claim 22, wherein a portion of the second fingers pass through the third edge collecting grid line in an insulated manner and are connected to the fourth edge collecting grid line.

24. **The** zero-busbar electrode structure according to claim 22, wherein the third edge is connected to the second edge via a second chamfer; and
in a direction from the third edge toward the fourth edge, the second finger and the first finger are alternately and sequentially arranged, and a fourth auxiliary grid line is disposed at the second chamfer, the fourth auxiliary grid line connecting the fourth edge collecting grid line to one of the second fingers closest to the third edge.

25. An IBC solar cell, comprising the zero-busbar electrode structure according to any one of claims 1 to 24.

26. A solar cell assembly, comprising a plurality of IBC solar cells according to claim 25.

27. A photovoltaic system, comprising the solar cell assembly according to claim 26.
